(19) Europäisches Patentamt
European Patent Office
Office européen des brevets

(11) **EP 4 786 244 A1**

(12) **EUROPEAN PATENT APPLICATION**
published in accordance with Art. 153(4) EPC

(43) Date of publication:
**05.08.2026 Bulletin 2026/32**

(21) Application number: **24872464.3**

(22) Date of filing: **27.09.2024**

(51) International Patent Classification (IPC):
**B60L 3/00** (2019.01)     **B60L 7/14** (2006.01)
**B60L 50/60** (2019.01)

(52) Cooperative Patent Classification (CPC):
**B60L 3/00; B60L 7/14; B60L 50/60;** Y02T 10/72

(86) International application number:
**PCT/JP2024/034554**

(87) International publication number:
**WO 2025/070680 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 28.09.2023  JP 2023167580
23.07.2024  JP 2024117630

(71) Applicant: **Nidec Advance Technology
Corporation
Muko-shi, Kyoto 6170007 (JP)**

(72) Inventor: **KAIDA, Michio
Muko-shi, Kyoto 617-0003 (JP)**

(74) Representative: **Viering, Jentschura & Partner
mbB
Patent- und Rechtsanwälte
Grillparzerstraße 14
81675 München (DE)**

(54) **PROGRAM, SYSTEM, AND DESIGN METHOD**

(57)     At least specifications of a motor, information of a moving body moved by the motor, a movement pattern of the moving body, and information of a battery that supplies power to the motor are used as input information for a computer. On the basis of the input information, at least one of a cruising distance, a cruising time, and power consumption of the moving body is outputted to the computer.

FIG. 4

EP 4 786 244 A1

**Description**

TECHNICAL FIELD

The present disclosure relates to a program for simulating a moving body moved by a motor, a system, and a design method for a moving body.

BACKGROUND ART

In the related art, for a moving body such as an electric vehicle, a configuration has been disclosed that includes a power consumption table in which a power consumption rate of vehicle travel is stored in association with vehicle speed, and that calculates a cruising distance based on a remaining battery level and the power consumption rate corresponding to an average speed over the most recent predetermined travel distance calculated based on the detected vehicle speed (see, for example, Patent Literature 1).

CITATIONS LIST

PATENT LITERATURE

Patent Literature 1: JP 2014-64364 A

SUMMARY OF INVENTION

TECHNICAL PROBLEMS

However, in a method of determining a power consumption rate based on a measured vehicle speed and calculating a cruising distance as in the related art, it is necessary to prepare a drivable electric vehicle, and measurement of the cruising distance of the electric vehicle during the design stage requires time and effort.

An object of the present invention is to provide a program that can facilitate the design of a motor and a moving body that includes a motor.

An object of the present invention is to provide a system that can facilitate the design of a motor and a moving body that includes a motor.

An object of the present invention is to provide a design method that can facilitate the design of a motor and a moving body that includes a motor.

SOLUTIONS TO PROBLEMS

A program of the present disclosure uses, as input information to a computer, at least a specification of a motor, information about a moving body moved by the motor, a movement pattern of the moving body, and information about a battery configured to supply power to the motor. The computer is caused to output at least one of a cruising distance, a cruising time, and a power consumption of the moving body based on the input information.

A system of the present disclosure includes: an input unit configured to receive input information; and a processing device configured to execute output processing of outputting at least one of a cruising distance, a cruising time, and a power consumption of a moving body based on the input information. The input information includes at least a specification of a motor, information about the moving body moved by the motor, a movement pattern of the moving body, and information about a battery configured to supply power to the motor.

A design method of the present disclosure includes outputting at least one of a cruising distance, a cruising time, and a power consumption of a moving body moved by power of a motor based on input information by using, as the input information, at least a specification of the motor, information about the moving body, a movement pattern of the moving body, and information about a battery configured to supply power to the motor.

According to a program of the present invention, it is possible to facilitate the design of a motor and a moving body including a motor.

According to a system of the present invention, it is possible to facilitate the design of a motor and a moving body including a motor.

According to design method of the present invention, it is possible to facilitate the design of a motor and a moving body including a motor.

BRIEF DESCRIPTION OF DRAWINGS

[FIG.1] FIG. 1 is a schematic view of an electric vehicle, which is an example of a moving body;

[FIG.2] FIG. 2 is a schematic sectional view of a motor;

[FIG.3] FIG. 3 is a schematic view of a system that executes a simulation;

[FIG.4] FIG. 4 is a schematic view of a simulation program;

[FIG.5] FIG. 5 is a diagram illustrating an example of a specification of a motor;

[FIG.6] FIG. 6 is a diagram illustrating an example of information about a moving body;

[FIG.7] FIG. 7 is a diagram illustrating an example of a movement pattern;

[FIG.8] FIG. 8 is a diagram illustrating an example of information about a battery;

[FIG.9] FIG. 9 is a diagram illustrating an example of information about a loss;

[FIG.10] FIG. 10 is a diagram illustrating an example of an environmental condition;

[FIG.11] FIG. 11 is a diagram illustrating an example of TN characteristics;

[FIG.12] FIG. 12 is a diagram illustrating an example of a current map;

[FIG.13] FIG. 13 is a diagram illustrating transitions of a required torque and a required rotational speed for the motor during movement of the moving body;

[FIG.14] FIG. 14 is a schematic view illustrating an example of a traveling state of an electric vehicle;

[FIG.15] FIG. 15 is a diagram illustrating a procedure of a design method using a program;

[FIG.16] FIG. 16 is a flowchart illustrating a known design method;

[FIG.17] FIG. 17 is a flowchart illustrating a design method according to the present disclosure;

[FIG.18] FIG. 18 is a schematic view of a system of a first modification;

[FIG.19] FIG. 19 is a schematic view of a program for executing a simulation of a second modification;

[FIG.20] FIG. 20 is a diagram illustrating a procedure of acquiring an optimum value of an outer diameter of a wheel;

[FIG.21] FIG. 21 is a schematic view of another example of the moving body;

[FIG.22] FIG. 22 is a diagram illustrating information about a moving body; and

[FIG.23] FIG. 23 is a schematic view of a simulation program according to the present modification.

DESCRIPTION OF EMBODIMENT

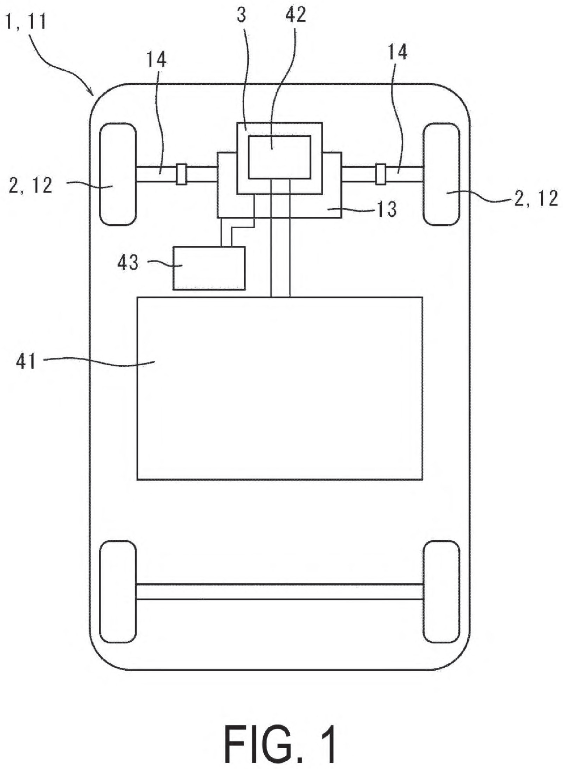

Exemplary embodiments of the present disclosure will be described in detail below with reference to the drawings. As illustrated in FIG. 1, an electric vehicle 11, which is an example of a moving body 1, travels by driving a wheel 12, which is an example of a rotating body 2, with a motor 3. Specifically, the moving body 1 includes the rotating body 2 that is rotated by the motor 3 to move the moving body 1.

Note that the electric vehicle 11 includes an xEV such as a BEV (Battery Electric Vehicle), a HEV (Hybrid Electric vehicle), a PHEV/PHV (Plug-in Hybrid Electric Vehicle/ Plug-in Hybrid Vehicle), and a FCEV/FCV (Fuel Cell Electric Vehicle/Fuel Cell Vehicle).

As illustrated in FIG. 1, the electric vehicle 11 includes the motor 3, a battery 41, an inverter 42, a controller 43, and a power transmission mechanism 13. The motor 3 rotates with power supplied from the battery 41. An output torque T33 of the motor 3 is transmitted to the wheel 12 through the power transmission mechanism 13. As the wheel 12 rotates, the electric vehicle 11 moves, i.e., travels.

Motor 3

Next, the motor 3 is described below with reference to the accompanying drawings. In the electric vehicle 11, the motor 3 is a synchronous motor. To be more specific, in this case, the motor 3 is an interior permanent magnet synchronous motor. Alternatively, the motor 3 may be a surface permanent magnet synchronous motor. In addition, various electric motors such as induction motors and DC brushless motors can be widely employed as motors used as a power source for the moving body.

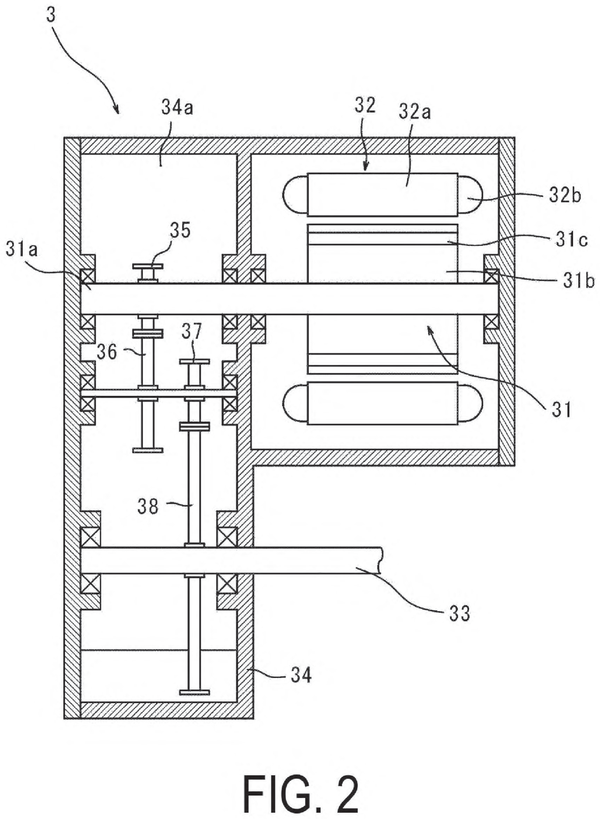

As illustrated in FIG. 2, the motor 3 includes a rotor 31 and a housing 34. Further, the motor 3 includes a stator 32, and gears 35, 36, 37, and 38. However, this is not limitative, and the motor 3 may not include the gears 35, 36, 37, and 38.

The housing 34 includes an internal space 34a. The rotor 31, the stator 32 and the gears 35, 36, 37, and 38 are housed in the internal space 34a. A fluid for cooling and lubricating the rotor 31, the stator 32 and the gears 35, 36, 37, and 38 is sealed in the internal space 34a of the housing 34.

In the internal space 34a of the housing 34, the stator 32 is fixed to the housing 34. Further, the rotor 31 is rotatably supported by the housing 34, and the stator 32 is disposed radially outside the rotor 31. The radially inner surface of the stator 32 faces the radially outer surface of the rotor 31 in a radial direction with a gap therebetween.

Rotor 31

The rotor 31 includes a motor shaft 31a, a rotor core 31b, and a magnet 31c. The motor shaft 31a is a cylindrical shaft. The motor shaft 31a is rotatably supported by the housing 34 through a bearing. Note that the motor shaft 31a is supported by the bearing at both axial ends and an intermediate portion. In addition, as long as the portion supported by the bearing has a cylindrical shape, other portions of the motor shaft 31a may not be cylindrical.

The rotor core 31b is formed by laminating electromagnetic steel sheets, for example. The rotor core 31b is a cylindrical member extending along the axial direction. A plurality of the magnets 31c are fixed to the rotor core 31b. The magnet 31c is housed and disposed inside the rotor core 31b. Note that the rotor core 31b is not limited to the above-described configuration.

Stator 32

The stator 32 includes a stator core 32a and a coil 32b. In addition, in the stator 32, an insulating member (not illustrated in the drawing) interposed between the stator core 32a and the coil 32b is disposed. The stator core 32a includes a plurality of magnetic pole teeth protruding radially inward from the internal peripheral surface of an annular yoke. The coil 32b is formed by winding a conductive wire around the magnetic pole teeth. The coil 32b is electrically connected to the battery 41 through the inverter 42. Power is supplied to the coil 32b from the battery 41 through the inverter 42.

Gears 35, 36, 37, and 38 and Output Shaft 33

The gears 35, 36, 37, and 38 engage with each other, and connect the motor shaft 31a and an output shaft 33. The output shaft 33 is rotatably supported by the housing 34 through a bearing. The output shaft 33 partially protrudes to the outside of the housing 34. The output shaft 33 is connected to a drive shaft 14 through the power transmission mechanism 13.

The gears 35, 36, 37, and 38 amplify a torque T3 of the motor 3, which is the output torque of the motor shaft 31a, by a predetermined gear ratio R3, and transmit it to the output shaft 33 as the output torque T33. Specifically, the output torque T33 and the torque T3 of the motor 3 satisfy the following Equation (1).
[Math 1]

$$T_{33} = R_3 \times T_3 \quad \cdots \quad (1)$$

In addition, the gears 35, 36, 37, and 38 decelerate a rotational speed N3 of the motor 3, which is the rotational speed of the motor shaft 31a, by the gear ratio R3, and transmit it to the output shaft 33 as an output rotational speed N33.

The output rotational speed N33 of the output shaft 33 and the rotational speed N3 of the motor 3 satisfy Equation (2).
[Math 2]

$$N_{33} = \frac{N_3}{R_3} \quad \cdot \cdot \cdot \quad (2)$$

The power transmission mechanism 13 includes a plurality of gears. When the plurality of gears engage with each other, the power transmission mechanism 13 connects the output shaft 33 with the drive shaft 14.

When the output torque of the output shaft 33 is the output torque T33, the output torque of the power transmission mechanism 13 is a torque T13, and the transmission ratio of the power transmission mechanism 13 is a transmission ratio R13, the following Equation (3) is satisfied.
[Math 3]

$$T_{13} = R_{13} \times T_{33} \quad \cdot \cdot \cdot \quad (3)$$

In addition, when the rotational speed of the output shaft 33 is the output rotational speed N33, the rotational speed of the output shaft of the power transmission mechanism 13 is a rotational speed N13, the rotational speed N13 and the output rotational speed N33 satisfy the following Equation (4).
[Math 4]

$$N_{13} = \frac{N_{33}}{R_{13}} \quad \cdot \cdot \cdot \quad (4)$$

Note that the transmission ratio R13 of the power transmission mechanism 13 may be fixed or variable. In the power transmission mechanism 13, a configuration whose transmission ratio R13 is variable is referred to as a transmission. When the power transmission mechanism 13 is a transmission, the transmission ratio R13 may be selected from among a plurality of predetermined transmission ratios R13, or the transmission ratio R13 may be continuously variable.

By changing the transmission ratio R13 of the power transmission mechanism 13, it is possible to select, from among a plurality of sets, a combination of the torque T3 of the motor 3 and the rotational speed N3 of the motor 3 when the electric vehicle 11 moves at a predetermined speed V or an acceleration a. As will be described in detail below, the motor 3 has different efficiency η, i.e., a power consumption, depending on the combination of the torque T3 of the motor 3 and the rotational speed N3 of the motor 3. Therefore, by appropriately selecting the transmission ratio R13 of the power transmission mechanism 13, the electric vehicle 11 can be moved with low power consumption. The present embodiment assumes that the power transmission mechanism 13 has a configuration in which the transmission ratio R13 can be changed. The power transmission mechanism 13 is connected to the controller 43, and the transmission ratio R13 set based on an instruction from the controller 43 is selected.

Inverter 42 and Controller 43

The controller 43 controls the electric vehicle 11. The controller 43 includes a computation unit that can execute arithmetic processing, and a storage unit for storing a variety of information, programs and the like required for control of the electric vehicle 11. The controller 43 controls the inverter 42 such that the electric vehicle 11 is accelerated or decelerated in response to an input to an accelerator pedal (not illustrated in the drawing) of the electric vehicle 11.

As described above, the motor 3 is an IPM synchronous motor and rotates when supplied with three-phase alternating currents of different phases. The moving body 1 includes the inverter 42 provided between the battery 41 and the motor 3. The inverter 42 may have a configuration combining switching elements such as an insulated gate bipolar transistor (IGBT), a bipolar transistor, a field effect transistor (FET), and a metal oxide semiconductor field effect transistor (MOSFET). Note that the above-described switching element may employ, for example, a configuration using SiC as a semiconductor material, but this is not limitative. The inverter 42 may be a full-bridge type combining the switching elements described above, for example. As the inverter 42, a wide variety of configurations capable of supplying three-phase alternating currents can be employed.

The inverter 42 converts a direct current output from the battery 41 into a three-phase AC current. Further, the inverter 42 supplies the converted AC current to the coil 32b of the motor 3. The inverter 42 is electrically connected to the controller 43, and is controlled by the controller 43. For example, the control of the inverter 42 by the controller 43 is performed by pulse width modulation (PWM) control. That is, the controller 43 performs ON/OFF control of the switching element of the inverter 42 through PWM control. Note that the control of the inverter 42 by the controller 43 is not limited to the PWM control.

The electric vehicle 11 according to the present embodiment executes a regenerative operation during deceleration, in which the rotor 31 is rotated by rotation of the wheel 12 to generate power. The motor 3 can perform a regenerative operation to generate power by being rotated by the rotating body 2.

In the regenerative operation, the battery 41 is charged by the current generated by the motor 3. Since the current generated by the motor 3 is alternating current, the inverter 42 converts the current into a direct current with which the battery 41 can be charged, thereby charging the battery 41. The electric vehicle 11 has the above-described configuration. Note that the regenerative operation is executed when the electric vehicle 11 is at or above a predetermined speed.

Simulations

In evaluating the performance of the electric vehicle 11 having the above-described configuration, at least one of the cruising distance, cruising time, and power consumption of the electric vehicle 11 is used. In view of this, a simulation in which at least one of a cruising distance 1D, a cruising time 1T and a power consumption 1P of the moving body 1 is output for the electric vehicle 11 is described below with reference to the accompanying drawings.

System 50

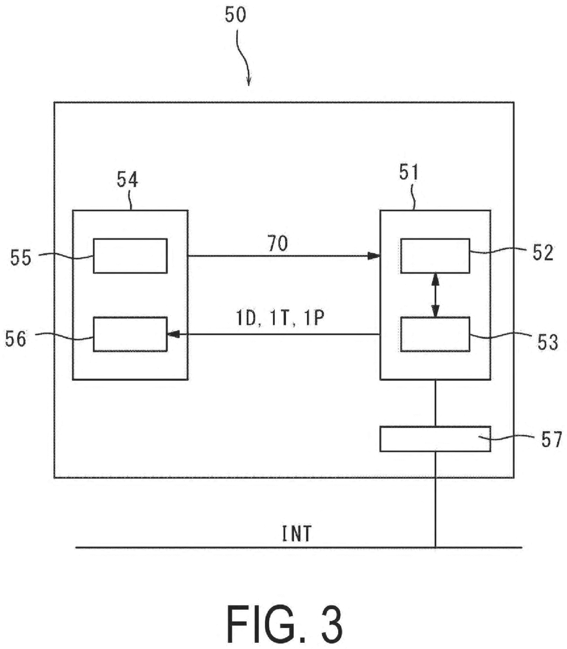

A system 50 that executes a simulation includes a computer 51 and an input/output device 54 as illustrated in FIG. 3, for example.

Computer 51

As illustrated in FIG. 3, the computer 51 includes a processing unit 52 and a storage unit 53. The processing unit 52 includes a processor that can execute arithmetic processing such as a central processing unit (CPU) and a micro processing unit (MPU), for example. The processing unit 52 has a configuration that can execute a program stored in the storage unit 53. To be more specific, in the computer 51, a simulation is executed by the processing unit 52 executing a simulation program 60 stored in the storage unit 53.

The storage unit 53 includes a storage device such as a read only memory (ROM), a random access memory (RAM), a hard disk drive (HDD), and a solid state drive (SSD), for example. Note that the storage unit 53 may include a detachable storage device. The storage unit 53 stores information required for the simulation, information generated by the simulation, and the like.

In addition, the input/output device 54 is connected to the computer 51, and the computer 51 serves as a control unit that controls the input/output device 54. To be more specific, the computer 51 has a configuration capable of receiving information input from an input unit 55 of the input/output device 54, and outputting (e.g., displaying) information at an output unit 56.

The computer 51 receives input information 70 input from the input/output device 54. The processing unit 52 executes output processing of outputting at least one of the cruising distance 1D, the cruising time 1T, and the power consumption 1P of the moving body based on the input information 70.

Input/Output Device 54

The input/output device 54 is a user interface that enables information input and output. The input/output device 54 includes the input unit 55 and the output unit 56.

Examples of the output unit 56 may include an image display device such as a liquid crystal display and an organic electric luminescence (EL) display, for example. As the output unit 56, a wide variety of configurations capable of displaying information received from the computer 51 under the control of the computer 51 can be employed. Note that the output unit 56 may have a configuration including an image forming device that forms an image on a sheet such as recording paper.

Examples of the input unit 55 may include a configuration capable of inputting numbers and characters, such as a keyboard, a mouse, and a touch input device. When a mouse or a touch input device is used, a configuration may be employed in which a character table is displayed on the output unit 56 and characters are selected from the character table by operating the input unit 55. The input unit 55 receives the input information 70. The input information 70 input from the input unit 55 may be supplied to the computer 51 as an electronic file collectively describing a plurality of types of information.

In addition, the system 50 is provided with a connecting unit 57 for connecting to the Internet INT. The connecting unit 57 is connected to the computer 51, and the information acquired via the Internet INT is sent from the connecting unit 57 to the computer 51.

Simulation Program 60

As described above, a simulation is executed by operating the simulation program 60 stored in the storage unit 53. Details of the simulation program 60 are described below with reference to the accompanying drawings.

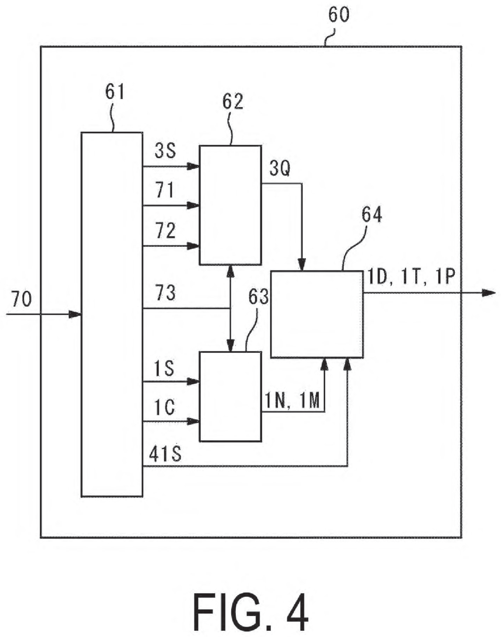

In the illustration of FIG. 4, the program 60 is divided into a plurality of modules according to the function. The program 60 includes an input module 61, a motor characteristic calculation module 62, a requirement condition calculation module 63, and an output module 64.

Input Information 70

The processing unit 52 receives the input information 70 input from the input/output device 54 through an operation of the input module 61. The input information 70 to the computer 51 includes at least a specification 3S of the motor 3, information 1S about the moving body 1 moved by the motor 3, a movement pattern 1C of the moving body 1, and information 41S about the battery 41 that supplies power to the motor 3.

That is, the input information 70 includes at least the specification 3S of the motor 3, the information 1S about the moving body 1 moved by the motor 3, the movement pattern 1C of the moving body 1, and the information 41S about the battery 41 that supplies power to the motor 3.

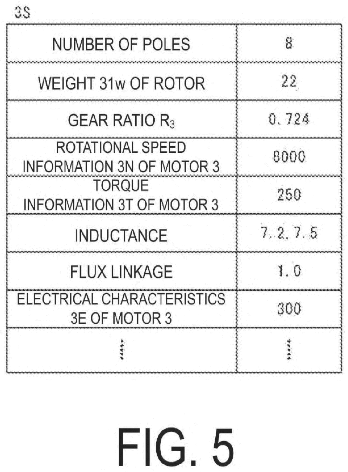

Each item of information included in the input information 70 is described below with reference to FIGS. 5 to 8. Note that in the following description, the specification 3S of the motor 3, the information 1S of the moving body 1, the movement pattern 1C and the information 41S about the battery 41 each include one or more types of information. In addition, each item of information may not include all information constituting the respective piece of information.

As illustrated in FIG. 5, the specification 3S of the motor 3 includes at least one of a weight 31w of the rotor 31, the gear ratio R3 of the motor 3, rotational speed information 3N of the motor 3, torque information 3T of the motor 3, and electrical characteristics 3E of the motor 3. The specification 3S of the motor 3 may further include the number of poles, inductance, and magnetic flux linkage.

The gear ratio R3 of the motor 3 may be a gear ratio resulting from a combination of the gears 35, 36, 37, and 38 included in the motor 3. Note that the gear ratio of the motor 3 that does not include the gears 35, 36, 37, and 38 is "1". In addition, the gear ratio may include information other than these. In addition, the number of gears is not limited to four.

The rotational speed information 3N of the motor 3 includes information about the rotational speed. In the specification 3S of the motor 3 illustrated in FIG. 5, examples of the rotational speed information 3N of the motor 3 may include a rated rotational speed. In addition, the rotational speed information 3N of the motor 3 may further include information about rotational speed such as maximum allowable rotational speed and speed constant. In addition, the rotational speed information 3N of the motor 3 may include information representing a rotational speed with respect to the applied voltage, a relationship between the voltage and the rotational speed, and the like, in forms such as a scatter diagram, a graph, and a relational expression, for example.

The torque information 3T of the motor 3 includes information about the torque of the motor 3. In the specification 3S of the motor 3 illustrated in FIG. 5, examples of the torque information 3T of the motor 3 may include a rated torque. In addition, the torque information 3T of the motor 3 may further include information about a torque, such as a stall torque and a torque constant. In addition, the torque information 3T of the motor 3 may include information representing a torque with respect to the applied voltage, a relationship between the voltage and the torque, and the like, in forms such as a TN curve, a graph, and a relational expression.

The inductance of the motor 3 includes information representing a d-axis inductance Ld and a q-axis inductance Lq of the coil 32b constituting the motor 3. As illustrated in FIG. 5, examples of the inductance may include the d-axis inductance Ld and the q-axis inductance Lq. Note that the inductance of the motor 3 may include information for acquiring the d-axis inductance Ld and the q-axis inductance Lq, in forms such as a scatter diagram, a graph, and a relational expression, for example.

The flux linkage includes information representing an armature flux linkage $\Psi$m resulting from the magnet 31c of the motor 3. Note that the flux linkage may include information for acquiring the armature flux linkage $\Psi$m, in forms such as a scatter diagram, a graph, and a relational expression.

The electrical characteristics 3E of the motor 3 include information representing a current and a voltage applied to the coil 32b of the motor 3 with respect to the applied voltage. As illustrated in FIG. 5, examples of the electrical characteristics 3E of the motor 3 may include a rated voltage. Note that the electrical characteristics 3E of the motor 3 may include a rated current, a starting current, and a counter electromotive force constant. Note that the electrical characteristics 3E of the motor 3 may include information about a current and a voltage such as an allowable current and a nominal voltage. In addition, information about an amount of current with respect to the applied voltage and the like may also be included. Further, the electrical characteristics 3E of the motor 3 may include information for acquiring information about a current and a voltage, in forms such as a scatter diagram, a graph, and a relational expression, for example.

Each item of information of the above-described specification 3S of the motor 3 is merely an example, and information other than the above-described information may also be included.

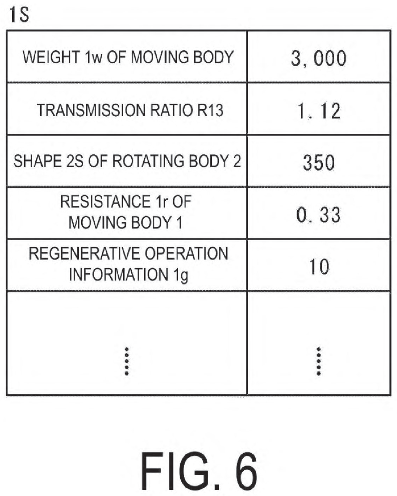

The information 1S of the moving body 1 includes information about the electric vehicle 11. As illustrated in FIG. 6, the information 1S of the moving body 1 includes at least one of a weight 1w of the moving body 1, the transmission ratio R13 of the power transmission mechanism 13 provided between the motor 3 and the rotating body 2, a shape 2S of the rotating body 2, a resistance 1r of the moving body 1 generated through movement of the moving body 1, and regenerative operation information 1g of the moving body 1.

Examples of the weight 1w of the moving body 1 may include a weight 11w of the electric vehicle 11. The weight may be a vehicle weight of the electric vehicle 11, or a gross vehicle weight obtained by adding an occupant weight and a baggage weight to the weight of the electric vehicle 11, for example.

The information 1S of the moving body 1 includes the transmission ratio R13 of the power transmission mechanism 13. When the power transmission mechanism 13 is a transmission, a plurality of the transmission ratios R13 may be provided. In addition, when the power transmission mechanism 13 is a continuously variable transmission, the transmission ratio R13 of the power transmission mechanism may include information for acquiring a range of the transmission ratio and the transmission ratio, in forms such as a scatter diagram, a graph, and a relational expression.

The shape 2S of the rotating body 2 of the moving body 1 includes information representing the shape of the rotating body 2 rotated by the motor 3. The electric vehicle 11 is an example of the moving body 1 that travels on a road. The electric vehicle 11 moves as the wheel 12, which is the rotating body 2, rotates. Therefore, as illustrated in FIG. 6, examples of the shape 2S of the rotating body 2 may include a radius R of the wheel 12, which is an example of the rotating body 2. Note that the shape of the rotating body 2 may include the circumference length of the wheel. In addition, the shape 2S of the rotating body 2 may include information representing the brand and size of a tire constituting a part of the wheel 12.

The resistance 1r of the moving body 1 is a resistance generated through movement of the moving body 1. Examples of the resistance 1r of the moving body 1 may include an air resistance coefficient resulting from the vehicle's motion. In addition, the resistance 1r of the moving body 1 may further include the rolling resistance coefficient of the wheel 12. In addition, when the shape of the rotating body 2 includes information representing the brand and size of the wheel 12, the rolling resistance coefficient of the wheel 12 may be acquired via the Internet INT based on the information representing the brand and size of the wheel 12 by executing the program 60 by the processing unit 52.

The information 1S of the moving body 1 includes the regenerative operation information 1g of the motor 3 of the moving body 1. For example, if a traveling speed 1V of the moving body 1 is low, the power generation through the regenerative operation may not be sufficiently performed. Therefore, as illustrated in FIG. 6, examples of the regenerative operation information 1g of the moving body 1 may include a minimum speed for performing regenerative operation in the moving body 1.

Each item of information of the information 1S of the moving body 1 described above is merely an example, and information other than the above-described information may also be included.

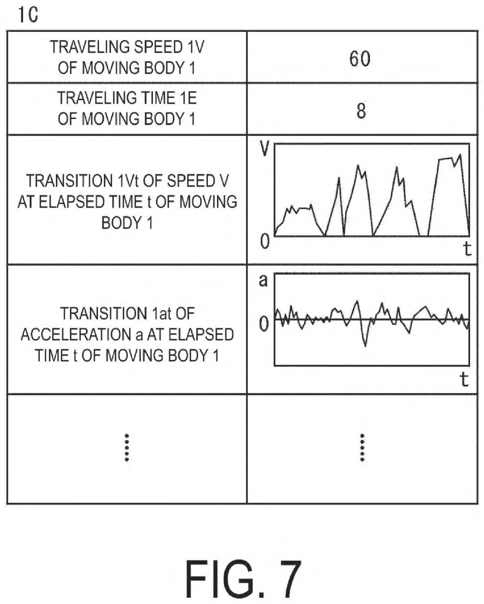

The movement pattern 1C of the moving body 1 includes the movement pattern 1C of the moving body 1. As illustrated in FIG. 7, the movement pattern 1C of the moving body 1 includes at least one of the traveling speed 1V, a traveling time 1E, a transition C1 of speed in a predetermined period, and a transition of acceleration C2 in a predetermined period.

The movement pattern 1C of the moving body 1 may include the traveling speed 1V of the moving body 1 and the traveling time 1E of the moving body 1.

The movement pattern 1C of the moving body 1 may include a transition 1Vt of the speed V at an elapsed time t of the moving body 1. As illustrated in FIG. 7, the transition 1Vt of the speed V at the elapsed time t of the moving body 1 is illustrated with the abscissa indicating the elapsed time t and the ordinate indicating the speed V. Note that the transition 1Vt of the speed V at the elapsed time t of the moving body 1 may include information representing a relationship between the traveling distance and the speed V, in forms such as a scatter diagram, a graph, and a relational expression.

The movement pattern 1C of the moving body 1 may include a transition 1at of the acceleration a at the elapsed time t of the moving body 1. As illustrated in FIG. 7, the transition 1at of the acceleration a at the elapsed time t of the moving body 1 is illustrated with the abscissa indicating the elapsed time t and the ordinate indicating the acceleration a. Note that the acceleration a at the elapsed time t of the moving body 1 may include information representing a relationship between the traveling distance and the speed V, in forms such as a scatter diagram, a graph, and a relational expression, for example.

Note that the transition 1Vt of the speed V at the elapsed time t of the moving body 1 and the transition 1at of the acceleration a at the elapsed time t of the moving body 1 can be standards defined by a country or region where the moving body 2 is used, for example. At this time, at least one of the transition 1Vt of the speed V at the elapsed time t of the moving body 1 and the transition 1at of the acceleration a at the elapsed time t of the moving body 1 may include a name or symbol of the standard. In this case, the processing unit 52 may execute the input module 61 to acquire it via the Internet INT.

Each item of information of the movement pattern 1C described above is merely an example, and information other than the above-described information may also be included.

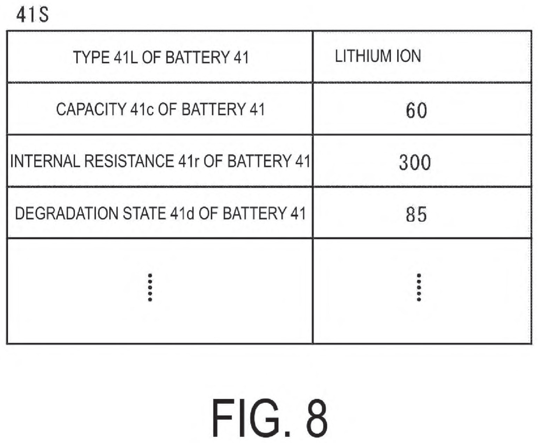

The information 41S about the battery 41 that supplies power to the motor 41 includes information about the battery 41 mounted on the moving body 1. As illustrated in FIG. 8, the information about the battery 41S includes at least one of a type 41L of the battery 41, a capacity of the battery 41, an internal resistance 41r of the battery 41, and a degradation state of the battery 41.

The information 41S about the battery 41 includes the type 41L of the battery 41. The type 41L of the battery 41 may include information representing the type of battery such as a lithium ion battery, a lithium polymer battery, and a nickel hydride battery, for example. As illustrated in FIG. 8, examples of the type 41L of the battery 41 may include a lithium ion battery. Note that when a general-purpose battery is used as the battery 41, the type 41L of the battery 41 may include a model number of the battery. The model number of the battery may be one used in the market, one defined by domestic or international standards, or one used internally by a business entity. When the type 41L of the battery 41 includes a model number of the battery, the processing unit 52 may acquire information from a database on a server via the Internet, for example.

The information 41S about the battery 41 includes a capacity 41c of the battery 41. The capacity 41c of the battery 41 may include information about the capacity of the battery 41 such as a maximum voltage, a maximum current, and charge/discharge curves. The information 41S about the battery 41 includes a weight 41w of the battery 41. Typically, the weight 41w of the battery 41 increases as the capacity 41c of the battery 41 increases. In addition, the weight 41w of the battery 41 is also related to the type 41L of the battery 41.

The information 41S about the battery 41 includes the internal resistance 41r of the battery 41. The internal resistance 41r of the battery 41 may include information about a relationship between the number of charge cycles and the internal resistance of the battery, in forms such as a scatter diagram, a graph, and a relational expression, for example.

Many batteries degrade through repeated charge and discharge. The information 41S about the battery 41 includes a degradation state 41d of the battery 41. Examples of the degradation state 41d of the battery 41 include a degradation ratio of the battery 41. The degradation ratio of the battery 41 is information representing the current maximum charge capacity as a ratio to the chargeable capacity in an unused state. The degradation state 41d of the battery may include the number of charge cycles and the remaining number of charge cycles. The remaining number of charge cycles refers to the number of times the battery can be charged before the capacity at full charge drops below a certain level. In addition, the degradation information 41d of the battery 41 may include information representing the degradation ratio and the number of charge cycles, in forms such as a scatter diagram, a graph, and a relational expression, for example.

Each item of information of the information about the battery 41S described above is merely an example, and information other than the above-described information may also be included.

When the moving body 1 moves, losses due to the driving of the motor 3 occur. Therefore, the input information 70 may further include loss information 71. The loss information 71 includes a plurality of types of information.

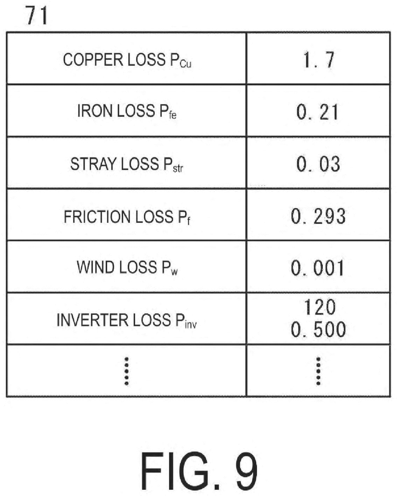

The loss information 71 includes information about losses that occur at the motor 3 during movement of the electric vehicle 11. As illustrated in FIG. 9, the loss information 71 includes at least one of a copper loss PCu, an iron loss Pfe, a stray loss Pstr, a friction loss Pf, a wind loss Pw, and an inverter loss Pinv.

The copper loss PCu is a power loss consumed as Joule heat by a conductive wire constituting the coil 32b or the like. The copper loss PCu is expressed by the following Equation (5) using a resistance value rCu of the conductive wire, a d-axis current Id, and a q-axis current Iq, for example.

[Math 5]

$$P_{Cu} = \frac{3}{2} r_{Cu} \times \left( I_d^2 + I_q^2 \right) \qquad \cdot \cdot \cdot (5)$$

As illustrated in FIG. 9, regarding the loss information 71, examples of the copper loss PCu may include the resistance value rCu of the conductive wire constituting the coil 32b or the like. Note that the above-described expression is an example, and different expressions may also be used. In that case, the copper loss PCu may include information for determining the copper loss PCu, in forms such as a scatter diagram, a graph, and a relational expression.

The iron loss Pfe is a loss that occurs at the iron core portion of the stator core 32a. The iron loss Pfe is expressed by the following Equation (6) using an iron loss coefficient Cfe, the rotational speed N3 of the motor 3, a Steinmetz exponent γ, the d-axis current Id, the q-axis current Iq, the d-axis inductance Ld, the q-axis inductance Lq, and the armature flux linkage Ψm, for example.

[Math 6]

$$P_{fe} = C_{fe} N_3^{\gamma} \left\{ (L_d I_d + \Psi_m)^2 + \left( L_q I_q \right)^2 \right\} \qquad \cdot \cdot \cdot (6)$$

As illustrated in FIG. 9, regarding the loss information 71, examples of the iron loss may include the iron loss coefficient Cfe. Other numerical values can be obtained from other input information. Note that the above-described expression is an example, and different expressions may also be used. In that case, the iron loss Pfe may include information for determining the iron loss Pfe, in forms such as a scatter diagram, a graph, and a relational expression.

The stray loss Pstr is a loss resulting from harmonic magnetic flux. The stray loss Pstr is expressed by the following Equation (7) using a stray loss coefficient Cstr, a frequency f of an input current I, the d-axis current Id, and the q-axis current Iq, for example.

[Math 7]

$$P_{str} = C_{str} \times (2\pi f)^2 \left(I_d^2 + I_q^2\right) \qquad \cdots \quad (7)$$

As illustrated in FIG. 9, regarding the loss information 71, examples of the stray loss may include a value E3 of the stray loss coefficient Cstr. Note that the above-described expression is an example, and different expressions may also be used. In that case, the stray loss Pstr may include information for determining the stray loss Pstr, in forms such as a scatter diagram, a graph, and a relational expression, for example.

The friction loss Pf is a loss resulting from friction of the bearing supporting the motor shaft 31a. The friction loss Pf is expressed by the following Equation (8) using a friction torque Tf and the rotational speed N3 of the motor 3, for example.

[Math 8]

$$P_f = T_f \times N_3 \qquad \cdots \quad (8)$$

As illustrated in FIG. 9, regarding the loss information 71, examples of the friction loss may include the friction torque Tf. Other numerical values can be obtained from other input information. Note that the above-described expression is an example, and different expressions may also be used. In that case, the friction loss Pf may include information for determining the friction loss Pf, in forms such as a scatter diagram, a graph, and a relational expression, for example.

The wind loss Pw is a loss resulting from the air resistance of the rotor 31 when the rotor 31 rotates. The wind loss Pw is expressed by the following Equation (9) using a wind loss coefficient kw and the rotational speed N3 of the motor 3, for example.

[Math 9]

$$P_w = k_w \times N_3^3 \qquad \cdots \quad (9)$$

As illustrated in FIG. 9, regarding the loss information 71, examples of the wind loss may include a value E5 of the wind loss coefficient kw. Other numerical values can be obtained from other input information. Note that the above-described expression is an example, and different expressions may also be used. In that case, the wind loss Pw may include information for determining the wind loss Pw, in forms such as a scatter diagram, a graph, and a relational expression, for example.

The inverter loss Pinv is a loss that occurs at the inverter 42. The processing unit 52 calculates losses at the motor 3 and the inverter 42 based on the loss information 71. The inverter loss Pinv is expressed by the following Equation (10) using a power source voltage Vdc, the input current I, rise time tr of the switching element, a fall time tf, a voltage Von of an on-period, a length ton of an on-period, an overshoot current Irr, an overshoot time trr, and a switching frequency fsw.

[Math 10]

$$P_{inv} = 3 \times \left[ \frac{2 \times V_{dc}}{\pi} \times I \times \left(t_r + t_f\right) + \frac{2 \times V_{on}}{\pi} \times I \times t_{on} + \frac{V_{dc}}{2} \times I_{rr} \times t_{rr} \right] \times f_{sw}$$

$$\cdots \quad (10)$$

As illustrated in FIG. 9, regarding the loss information 71, examples of the inverter loss may include the switching frequency fsw and the length ton of the on-period. Other numerical values can be obtained or calculated from other input information. Note that the above-described expression is an example, and different expressions may also be used. In that case, the inverter loss Pinv may include information for determining the inverter loss Pinv, in forms such as a scatter diagram, a graph, and a relational expression, for example.

Each item of information of the loss information 71 described above is merely an example, and information other than the above-described information may also be included.

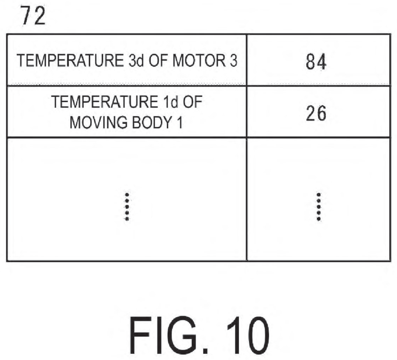

The performances of the motor 3, the battery 41, the inverter 42 and the like change depending on the environmental condition, particularly temperature. Therefore, the input information 70 further includes environment information 72. As illustrated in FIG. 10, the environment information 72 includes a temperature 3d of the motor 3 and the temperature of the moving body. Specifically, the input information 70 further includes the environment information 72 including at least one of the temperature 3d of the motor 3 and a temperature 1d of the moving body 1.

An example of the temperature 3d of the motor 3 is the temperature of the outer surface of the housing 34 of the motor 3. In addition, the temperature 3d of the motor 3 may be the temperature of another part such as the temperature of the motor shaft 31d. Note that the temperature 3d of the motor 3 may include other information. In addition, the temperature 3d of the motor 3 is not limited to specific numerical values. For example, the temperature 3d of the motor 3 may include information for determining the temperature 3d of the motor 3, in forms such as a scatter diagram, a graph, and a relational expression, for example.

An example of the temperature 1d of the moving body 1 is an outside air temperature, which is the temperature around the moving body 1. In addition, the temperature 1d of the moving body 1 may include the temperature of the battery 41 and the temperature of the inverter 42. In addition, information other than the above-described information may be included. In addition, the temperature 1d of the moving body 1 is not limited to specific numerical values, and may include information for determining the temperature 1d of the moving body 1, in forms such as a scatter diagram, a graph, and a relational expression, for example.

The input information 70 may include required information other than the above-described information. Therefore, the input information 70 may include other information 73. Examples of the other information 73 may include an operating ratio of an engine/motor of a hybrid vehicle. Further, the examples may also include information required for acquiring at least one of the cruising distance, cruising time and power consumption of the moving body 1.

Each module of the program 60 includes arithmetic expressions for computation using the input information 70. The other information 73 may include information for changing the arithmetic expression included in each module. In addition, the information included in the input information 70 may include a scatter diagram, a graph, a relational expression, and the like.

Motor Characteristic Calculation Module 62

As illustrated in FIG. 4, the processing unit 52 executes the motor characteristic calculation module 62 of the program 60, and calculates the characteristics of the motor 3 based on the specification 3S of the motor 3. In addition, the processing unit 52 may also use the information included in the loss information 71, the information included in the environment information 72, and the other information 73.

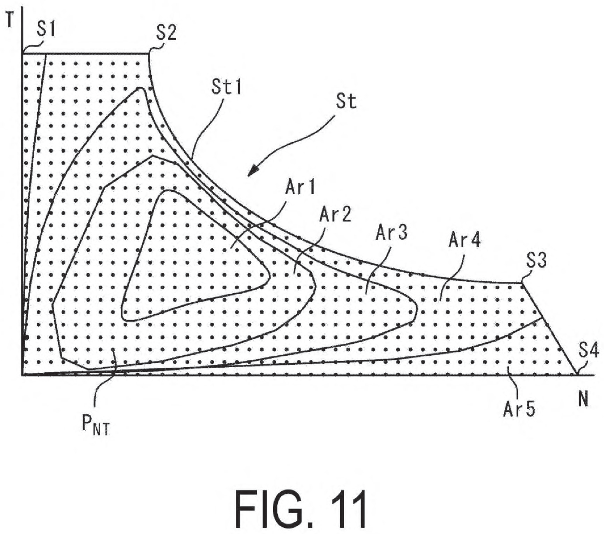

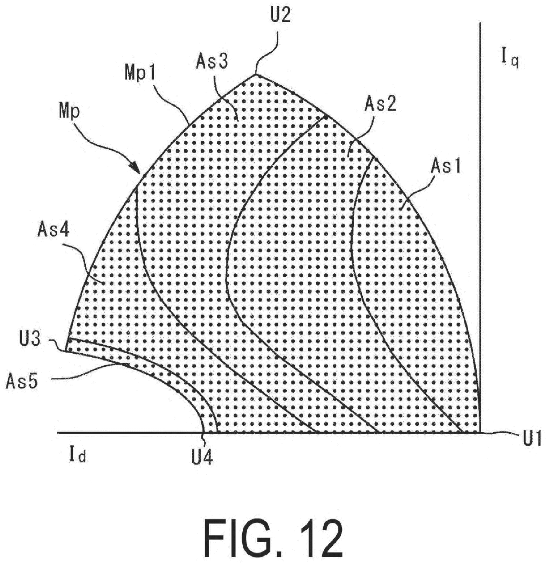

The characteristics 3Q of the motor 3 may include TN characteristics St representing a relationship between the torque T3 of the motor 3 and the rotational speed N3 of the motor 3 of FIG. 11, a current map Mp representing a relationship between the d-axis current Id and the q-axis current Iq of FIG. 12, and the efficiency $\eta$, for example. The TN characteristics St illustrated in FIG. 11 and the current map Mp illustrated in FIG. 12 correspond to each other. In addition, other information may be used.

In the TN characteristics St illustrated in FIG. 11, the abscissa indicates the rotational speed N3 of the motor 3 and the ordinate indicates the torque T3 of the motor 3. Feature points on a solid line St1 of the TN characteristics St illustrated in FIG. 11 are referred to as feature points S1 to S4. The portion from the feature point S1 to the feature point S2 of the solid line St1 of the TN characteristics St illustrated in FIG. 11 represents a relationship between the rotational speed N3 of the motor 3 and the maximum value of the torque T3 of the motor 3 in a maximum torque per ampere (MTPA) region of each current. Note that the MTPA region represents a relationship between the rotational speed N3 of the motor 3 and the torque T3 of the motor 3 when a control is performed to maximize the motor torque generated with a constant current amplitude. In the MTPA region, the solid line St1 represents the maximum value of the torque T3 of the motor 3.

The portion from the feature point S2 to the feature point S3 of the solid line St1 of the TN characteristics St represents a relationship between the rotational speed N3 of the motor 3 and the maximum value of the torque T3 of the motor 3 in a constant power speed range (CPSR) region. Note that the CPSR region represents a relationship between the rotational speed N3 of the motor 3 and the torque T3 of the motor 3 when a control is performed to maximize the torque T3 of the motor 3 obtained with a constant output of the motor 3. In the CPSR region, the solid line St1 represents the maximum torque T3 of the motor 3. In the CPSR region, the rotational speed N3 of the motor 3 is higher than in the MTPA region.

The portion from the feature point S3 to the feature point S4 of the solid line St1 of the TN characteristics St represents a relationship between the rotational speed N3 of the motor 3 and the maximum value of the torque T3 of the motor 3 in a maximum torque per voltage (MTPV) region of each voltage. Note that the MTPV region represents a relationship between the rotational speed N3 of the motor 3 and the torque T3 of the motor 3 when a control is performed to maximize the motor torque generated with a constant voltage amplitude. In the MTPV region, the solid line St1 represents the maximum value of the torque T3 of the motor 3. In the MTPV region, the rotational speed N3 of the motor 3 is higher than in the CPSR region.

As described above, the solid line St1 of FIG. 11 represents the maximum value of the torque T3 of the motor 3 at a given rotational speed N3 of the motor 3. That is, the motor 3 can operate within the range surrounded by the solid line.

FIG. 12 illustrates the current map Mp representing a relationship between the d-axis current Id and the q-axis current Iq determined based on a torque and a rotational speed. A solid line Mp1 of the current map Mp corresponds to the solid line St1 of the TN characteristics St. To be more specific, feature points on the solid line Mp1 of the current map Mp illustrated in FIG. 12 are referred to as feature points U1 to U4. In the TN characteristics St of FIG. 11, the portion from the feature point S1 to the feature point S2 of the solid line St1 corresponds to a curve from a feature point U1 to a feature point U2 of the solid line Mp1 of the current map Mp. That is, in the solid line Mp1 of the current map Mp, the curve from the feature point U1 to the feature point U2 is the maximum torque in the MTPA region, and the MTPA region is a region on the lower side of the curve from the feature point U1 to the feature point U2 of the solid line Mp1.

In addition, the portion from the feature point S2 to the feature point S3 of the solid line St1 of the TN characteristics St corresponds to a curve from the feature point U2 to feature point U3 of the solid line Mp1 of the current map Mp. That is, the curve from the feature point U2 to the feature point U3 of the solid line Mp1 of the current map Mp is the maximum torque in the CPSR region, and the CPSR region is a region on the lower side of the curve from the feature point U2 to the feature point U3.

Further, the portion from the feature point S3 to the feature point S4 of the solid line St1 of the TN characteristics St corresponds to the curve from the feature point U3 to the feature point U4 of the solid line Mp1 of the current map Mp. That is, the curve from the feature point U3 to the feature point U4 of the solid line Mp1 of the current map Mp is the maximum torque in the MTPV region, and the MTPV region is a region between the curve from the feature point U3 to the feature point U4 and the curve from the feature point U3 to the feature point U4 of the solid line Mp1. That is, the motor 3 can operate within the range surrounded by the solid line Mp1.

That is, the region surrounded by the solid line St1 of the TN characteristics St corresponds to the region surrounded by the solid line Mp1 of the current map Mp. The dots illustrated in the TN characteristics St of FIG. 11 are example values of a torque TR3 of the motor 3 and the rotational speed N3 of the motor 3. The dots illustrated in the current map Mp of FIG. 12 are example values of the d-axis current Id and the q-axis current Iq. The dots illustrated in the TN characteristics St of FIG. 11 and the dots illustrated in the current map Mp of FIG. 12 correspond to each other in a one-to-one relationship. For example, the feature point S2 of the TN characteristics St corresponds to the feature point U2 of the current map. That is, the system 50 determines the d-axis current Id and the q-axis current Iq by running the program 60.

In addition, the TN characteristics St and the current map Mp of the motor 3 change depending on the temperature of the motor 3. Therefore, the motor characteristic calculation module 62 may calculate the TN characteristics St and the current map Mp that change depending on at least one of the temperature of the motor 3 and the surrounding temperature. In this manner, the influence of temperature can be taken into consideration in the TN characteristics St and the current map Mp of the motor 3. Note that at least one of the TN characteristics St and the current map Mp may be configured to change depending on the temperature of the motor 3, the surrounding temperature, and the like.

In addition, the efficiency η is determined in accordance with the loss information 71. To be more specific, when the output of the motor 3 is represented as an output Pe, and the loss that occurs when the motor 3 is driven is represented as a loss Ploss, the efficiency η is expressed by the following Equation (11).
[Math 11]

$$\eta = \frac{P_e}{P_e + P_{loss}} \quad \cdot \cdot \cdot \quad (1 1)$$

As described above, the copper loss PCu, the iron loss Pfe and the stray loss Pstr change depending on the d-axis current Id and the q-axis current Iq. In addition, the inverter loss Pinv changes depending on the input current I and the switching frequency fsw. Further, the friction loss Pf and the wind loss Pw change depending on the rotational speed N3 of the motor 3. Therefore, the processing unit 52 can calculate the efficiency η based on the d-axis current Id and the q-axis current Iq corresponding to the rotational speed N3 of the motor 3 and the torque T3 of the motor 3. In other words, the processing unit 52 can calculate the efficiency η corresponding to the rotational speed N3 of the motor 3 and the torque T3 of the motor 3. The dots of the TN characteristics St illustrated in FIG. 11 include information about the rotational speed N3 of the motor 3, the torque T3 of the motor 3, and the efficiency η. In addition, the dots of the current map Mp illustrated in FIG. 12 include information about the d-axis current Id, the q-axis current Iq and the efficiency η.

In the TN characteristics St illustrated in FIG. 11, contour lines dividing the efficiencies η of the dots into regions Ar1 to Ar5 of given ranges are illustrated. In FIG. 11, the region where the efficiency is equal to or greater than a first efficiency η1 is defined as a first region Ar1, the region where the efficiency is less than the first efficiency η1 and equal to or greater than a second efficiency η2 is defined as a second region Ar2, the region where the efficiency is less than the second efficiency η2 and equal to or greater than a third efficiency η3 is defined as a third region Ar3, the region where the efficiency is less than the third efficiency η3 and equal to or greater than a fourth efficiency is defined as a fourth region Ar4, and the region where the efficiency is less than the fourth efficiency η4 is defined as a fifth region Ar5. As illustrated in the TN characteristics in FIG. 11, it can be seen that the center portion of the torque T3 of the motor 3 and the rotational speed N3 of the motor 3 is the region Ar1 having the highest efficiency, and the efficiency decreases outward with increasing distance from the region Ar1. As described above, the value of the efficiency η is calculated at each representative point Pt, and the efficiency η may differ even in the same region.

In addition, in the current map Mp illustrated in FIG. 12, the losses Ploss at the points Ps are divided into respective regions of given ranges. In FIG. 12, the region where the loss Ploss is less than a first loss Pl1 is defined as a first region As1, the region where the loss Ploss is equal to or greater than the first loss Pl1 and less than a second loss Pl2 is defined as a second region As2, the region where the loss Ploss is equal to or greater than the second loss Pl2 and less than a third loss Pl3 is defined as a third region As3, the region where the loss Ploss is equal to or greater than the third loss Pl3 and less than a fourth loss Pl4 is defined as a fourth region As4, and the region where the loss Ploss is equal to or greater than the fourth loss Pl4 is defined as a fifth region As5. As illustrated in FIG. 12, in the current map Mp, the loss Ploss is small in a portion where the difference between the d-axis current Id and the q-axis current Iq is small and both are small, and the loss Ploss increases as both the d-axis current Id and the q-axis current Iq increase. In addition, the loss Ploss is large in a region where the d-axis current Id is large and the q-axis current Iq is small.

Note that in some situations the input information 70 may be insufficient for the processing unit 52 to execute the motor characteristic calculation module 62. In this case, the processing unit 52 may determine the presence/absence of appropriate information in the storage unit 53, and may read the appropriate information from the storage unit 53 when there is appropriate information. In addition, when there is no appropriate information, the processing unit 52 may prompt the user to input information, and may connect to an external network such as the Internet and supplement an appropriate value with reference to a representative value, a customary value, a value of an equivalent motor, or the like. In addition, the input information 70 may be added by the processing unit 52 executing the input module 61. Furthermore, the processing unit 52 may execute an information acquisition program (not illustrated in the drawing) that operates in conjunction with the program 60 to acquire information and add or change the input information 70.

Note that the TN characteristics St and the current map Mp may include information about a pair PNT, the efficiency η, the d-axis current Id, the q-axis current Iq, and the loss Ploss. In this manner, even when the rotational speed N3 of the motor 3 and the torque T3 of the motor 3 do not overlap the representative point Pt, approximate values of the efficiency η and the loss Ploss can be determined by selecting the closest representative point Pt, whereby information with higher accuracy can be output.

Requirement Condition Calculation Module 63

The processing unit 52 executes the requirement condition calculation module 63 to calculate a requirement condition as a condition required for moving the electric vehicle 11. The processing unit 52 uses, as variables, the information included in the information 1S of the moving body 1 and the information included in the movement pattern 1C. Alternatively, the processing unit 52 may use the information included in the other information 73 as variables.

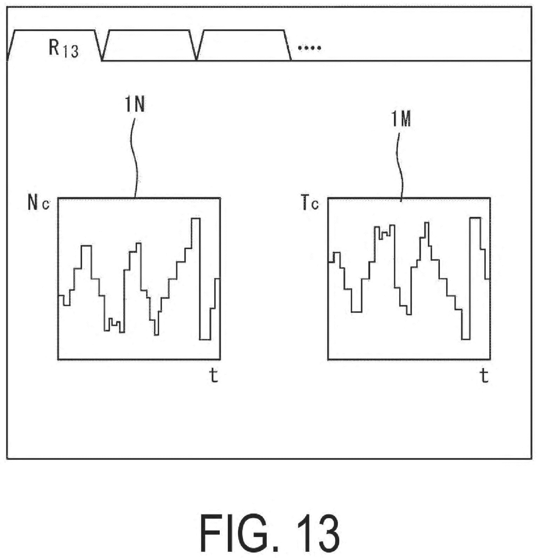

That is, the processing unit 52 executes the requirement condition calculation module 63 to calculate the requirement condition required for moving the electric vehicle 11. The speed and acceleration of the electric vehicle 11 are determined by the rotational speed and torque of the motor 3. In other words, when moving the electric vehicle 11, the motor 3 is required to rotate at a rotational speed and torque corresponding to the movement of the electric vehicle 11. The rotational speed and torque required for the motor 3 are referred to as a required rotational speed Nc and a required torque Tc. That is, the requirement condition includes one of the required rotational speed Nc and the required torque Tc. Further, at least one of the speed V and the acceleration a of the electric vehicle 11 may change with the elapsed time t. In such a case, the required rotational speed Nc and the required torque Tc also change with the elapsed time t. As such, examples of the requirement condition may include a transition 1N of the required rotational speed Nc with the elapsed time t and a transition 1M of the required torque Tc with the elapsed time t, as illustrated in FIG. 13.

As illustrated in FIG. 13, the processing unit 52 calculates, for each transmission ratio R13 of the power transmission mechanism 13, the transition 1N of the required rotational speed with a change in the elapsed time t and the transition 1M of the required torque with a change in the elapsed time t. Note that while the abscissa indicates the elapsed time t in FIG. 13, the same information can be obtained even when the abscissa indicates the traveling distance.

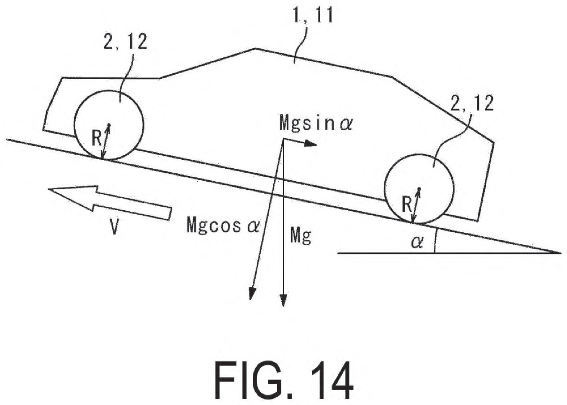

For example, as illustrated in FIG. 14, it is assumed that the electric vehicle 11 travels on a slope with an angle α. The processing unit 52 executes the requirement condition calculation module 63. The processing unit 52 calculates power Fp for moving the electric vehicle 11 as a requirement condition using the following Equation (12).

[Math 12]

$$F_P = M\frac{dV}{dt} + \frac{\rho C_d A_F}{2}V^2 + f_r Mg\cos\alpha + Mg\sin\alpha \quad \cdot \cdot \cdot \quad (12)$$

Fp: POWER
M: WEIGHT OF ELECTRIC VEHICLE 11
V: SPEED OF ELECTRIC VEHICLE 11 AT ELAPSED TIME t
ρ: AIR VISCOSITY COEFFICIENT

Cd: AIR RESISTANCE COEFFICIENT
AF: PROJECTION AREA OF ELECTRIC VEHICLE 11 IN TRAVELING DIRECTION
fr: COEFFICIENT OF FRICTION BETWEEN ROAD AND ELECTRIC VEHICLE 11
g: GRAVITATIONAL ACCELERATION
α: INCLINATION ANGLE OF SLOPE

Further, the torque T13 supplied to the drive shaft 14 for the electric vehicle 11 to move at the speed V at the elapsed time t is determined by the following Equation (13).
[Math 13]

$$T_{13} = R \times F_P = R \left( M \frac{dV}{dt} + \frac{\rho C_d A_F}{2} V^2 + f_r Mg cos\alpha + Mg sin\alpha \right)$$

$$\cdots \ (13)$$

R: RADIUS OF WHEEL 2 OF ELECTRIC VEHICLE 11
The inertia force, rolling resistance, and gravity are determined based on a weight M of the electric vehicle 11. In addition, the inertia force is proportional to acceleration, that is, a time derivative of speed. The air resistance varies in proportion to a frontal projection area and an aerodynamic resistance coefficient of the electric vehicle 11 and to the square of the speed. Therefore, the processing unit 52 calculates the inertia force and the air resistance based on the speed V and the acceleration a at a certain elapsed time t acquired from a transition C4 of the acceleration or a transition C3 of the speed of the movement pattern 1C.
The processing unit 52 executes the requirement condition calculation module 63 to calculate the power Fp and the torque T13 at a predetermined elapsed time t.
To be more specific, the processing unit 52 acquires the speed V of the electric vehicle 11 at a predetermined elapsed time t from at least one of the transition C3 of the speed and the transition C4 of the acceleration illustrated in FIG. 7. Further, the processing unit 52 calculates the power Fp and the torque T13 of the electric vehicle 11 using Equation (8) and Equation (9). In addition, the processing unit 52 calculates the rotational speed N13 from the speed of the electric vehicle 11 and the radius R of the wheel 12.
The rotational speed N3 of the motor 3 output from the motor 3 and the torque T3 of the motor 3 are transmitted to the drive shaft 14 through the power transmission mechanism 13. Therefore, the processing unit 52 calculates the required rotational speed and the required torque for the motor 3 at a predetermined elapsed time t based on the rotational speed N13, the torque T13 and the transmission ratio R13 of the power transmission mechanism 13. That is, the processing unit 52 executes the requirement condition calculation module 63 to calculate the required rotational speed and the required torque from the rotational speed N13 and the torque T13. The processing unit 52 calculates the required rotational speed and the required torque for each transmission ratio R13, for example. In addition, when the transmission ratio R13 is a continuously variable transmission ratio, the required rotational speed and the required torque may be a correlation, such as a functional relationship, set within a given range.
In addition, in Equation (13), it is not necessary to take all coefficients into consideration, and it is possible to take into consideration only some coefficients. It is possible to employ a wide variety of configurations of determining the required torque based on the power Fp for moving the electric vehicle 11 at a required speed V, and the radius R of the wheel 12.
As illustrated in FIG. 7, the speed V and the acceleration a of the electric vehicle 11 transition with a change in the elapsed time t. Therefore, the processing unit 52 executes the requirement condition calculation module 63 to calculate the transition 1N of the required rotational speed Nc required for the motor 3 with a change in the elapsed time t and the transition 1M of the required torque Tc with a change in the elapsed time t. In this manner, the processing unit 52 executes the requirement condition calculation module 63 to calculate the transition 1N of the required rotational speed Nc with a change in the elapsed time and the transition 1M of the required torque Tc with a change in the elapsed time t required for the motor 3 when the electric vehicle 11 moves. Then, the processing unit 52 calculates the pair PNT of the rotational speed N3 of the motor 3 and the torque T3 of the motor 3 having a high efficiency η based on the TN characteristics St. Further, the processing unit 52 calculates the d-axis current Id and the q-axis current Iq corresponding to the pair PNT with reference to the current map Mp.
In some cases, the electric vehicle 11 may have a function of moving while maintaining a constant speed in a place, such as an expressway, where the vehicle can travel for a long distance or for a long time without stopping. Even in such a case, the transition 1N of the required rotational speed Nc required for the motor 3 with a change in the elapsed time t and the transition 1M of the required torque Tc with a change in the elapsed time t can be calculated in the same manner as described above.
That is, when a constant speed is maintained, the speed does not change irrespective of changes in time or

14

distance. Therefore, the processing unit 52 executes the requirement condition calculation module 63 to calculate the transition 1N of the required rotational speed Nc required for the motor 3 with a change in the elapsed time t and the transition 1M of the required torque Tc with a change in the elapsed time t based on a constant speed C1, the power Fp, and the transmission ratio R13.

Output Module 64

As illustrated in FIG. 4, the processing unit 52 executes the output module 64 to output at least one of the cruising distance 1D, the cruising time 1T, and the power consumption 1P of the moving body 1 to the processing unit 52 based on the input information 70. In this case, the processing unit 52 outputs the cruising distance 1D, the cruising time 1T, and the power consumption 1P of the electric vehicle 11.

The processing unit 52 executes the output module 64 to output at least one of the cruising distance 1D, the cruising time 1T, and the power consumption 1P based on the TN characteristics St, the current map Mp, the required rotational speed Nc at the elapsed time t and the required torque Tc at the elapsed time t. In addition, the processing unit 52 may use the information included in the other information 73.

A specific operation of the output module 64 is described below. Note that the following description assumes that the speed V and the acceleration a of the electric vehicle 11 transition with the elapsed time t. The processing unit 52 acquires the required rotational speed Nc and the required torque Tc at a predetermined elapsed time t from the transition 1N of the required rotational speed with a change in the elapsed time t and the transition 1M of the required torque Tc with a change in the elapsed time t (see FIG. 13).

Further, the processing unit 52 acquires the torque T3 of the motor 3, the rotational speed N3 of the motor 3 and the efficiency η corresponding to the required rotational speed and the required torque with reference to the TN characteristics St. Note that when determining the rotational speed N3 of the motor 3 and the torque T3 of the motor 3 from the required rotational speed and the required torque, the processing unit 52 may employ a closest pair PNT. In addition, the processing unit 52 may determine approximate values with reference to the efficiency η of the pair PNT.

The processing unit 52 selects the d-axis current Id and the q-axis current Iq corresponding to the pair PNT based on the current map Mp.

The processing unit 52 executes the output module 64 to output the input current I of the motor 3 at a predetermined elapsed time t based on the d-axis current Id and the q-axis current Iq. Note that the input current I of the motor 3 at a predetermined elapsed time t is output along with the loss determined based on the current and the loss Ploss determined based on the d-axis current Id and the q-axis current Iq. Note that the input current I along with the loss may be a value obtained by dividing, by the efficiency η, the current determined based on the d-axis current Id and the q-axis current Iq, for example.

Further, the processing unit 52 calculates the required input current I at a predetermined elapsed time t.

Note that as described above, the plurality of transmission ratios R13 are set for the electric vehicle 11 to enable shifting. Therefore, as illustrated in FIG. 13, the required rotational speed and the required torque required for the electric vehicle 11 to travel at a predetermined speed V and acceleration a differ for each transmission ratio R13 of the power transmission mechanism 13.

In such a case, the processing unit 52 executes the output module 64 to output the transmission ratio, the rotational speed N3 of the motor 3 and the torque T3 of the motor 3 that increases the efficiency η with reference to the TN characteristics St illustrated in FIG. 11. Then, the processing unit 52 outputs the power consumption 1P during the movement in accordance with the transition C3 of the speed based on the selected rotational speed N3 of the motor 3 and torque T3 of the motor 3. The processing unit 52 outputs the power consumption 1P required for the movement by integrating the input current I over the total elapsed time.

In this manner, by executing the program 60, the processing unit 52 can output at least one of the cruising distance 1D, the cruising time 1T, and the power consumption 1P. In addition, the program 60 can also provide recommendations for efficiently operating the motor 3, such as recommending which of the plurality of transmission ratios R13 should be selected.

In addition, by executing the output module 64, the processing unit 52 can output the cruising distance 1D, the cruising time 1T, and the power consumption 1P for the case where movement at the constant speed C1 is set in the movement pattern 1C. Further, by executing the output module 64, the processing unit 52 can output the cruising distance 1D and the power consumption 1P for the case where the traveling time 1E is set in the movement pattern 1C. More specifically, in the case where the movement is at a constant speed C1 or the traveling time is predetermined, the rotational speed N3 of the motor 3 and the torque T3 of the motor 3 are assumed to be constant regardless of the elapsed time or the traveling distance.

The processing unit 52 executes the output module 64 to output the cruising distance 1D, the cruising time 1T, and the power consumption 1P, and the computer 51 sends them to the output unit 56 of the input/output device 54. The input/output device 54 displays the cruising distance 1D, the cruising time 1T, and the power consumption 1P on the output unit 56.

The cruising distance 1D and the cruising time 1T that are output as a result of execution of the output module 64 by the processing unit 52 may be the actual distance and time, or may be the ratio with respect to a separately given target cruising distance or target cruising time. For example, it is assumed that the target cruising distance is 510 km. It is assumed that the cruising distance 1D output as a result of execution of the output module 64 by the processing unit 52 in this state is 560 km. Then, the processing unit 52 may output the actual distance 560 km as the cruising distance 1D, or may output the ratio 1.1 or 110%. In addition, both the actual distance and the ratio may be output.

In addition, as the power consumption 1P output as a result of execution of the output module 64 by the processing unit 52, the actual power consumption or the residual quantity of the battery 41 may be output. For example, it is assumed that when a capacity D2 of the battery 41 is given as 60 kWh, the calculated value of the amount of electric energy consumption output as a result of execution of the output module 64 by the processing unit 52 is 42 kWh. Then, the processing unit 52 may output the actual amount of electric energy 42 kWh as the power consumption 1P, the remaining amount of electric energy 18 kWh, the ratio, 0.7 or 70%, of the consumed amount of electric energy with respect to the capacity D2 of the battery, or the ratio, 0.3 or 30%, of the remaining amount of electric energy with respect to the capacity D2 of the battery. In addition, both the actual amount of electric energy and the ratio may be output. In addition, the amount of electric energy consumed by the electric vehicle 11 to travel a predetermined distance may be the power consumption 1P.

The program 60 described above is divided into modules 61, 62, 63 and 64. The processing unit 52 executes the motor characteristic calculation module 62, the requirement condition calculation module 63 and the output module 64 to output the cruising distance 1D, the cruising time 1T, and the power consumption 1P from the input information 70. However, this is not limitative, and the program 60 may include other modules. In addition, at least two of the above-described modules may be combined into a single module. Furthermore, the program 60 may be composed of a single module.

Simulation Method

Next, a simulation is described below with reference to the accompanying drawings. In a simulation using the program 60 illustrated in FIG. 4, the cruising distance 1D, the cruising time 1T, and the power consumption 1P are acquired based on the input information 70 described above.

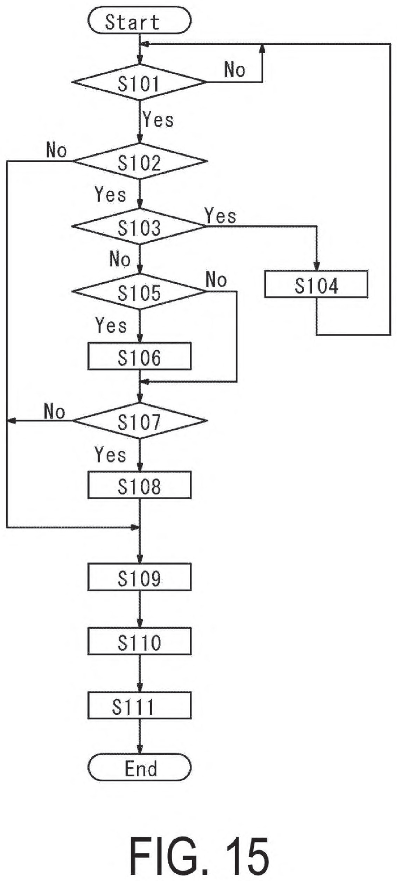

As illustrated in FIG. 15, at step S101, the processing unit 52 waits until the input information 70 is input. More specifically, the processing unit 52 repeats step S101 until the input information 70 is input, that is, while step S101 is No.

**[0147]** When the processing unit 52 confirms receipt of an input of the input information 70, the processing becomes Yes at step S101 and proceeds to step S102. At step S102, the processing unit 52 executes the input module 61 to confirm whether there is information not included in the input information 70. When the processing unit 52 determines that there is information not included in the input information, the processing becomes Yes at step 102 and proceeds to step S103.

At step S103, the processing unit 52 confirms whether the operator performs a re-entry. When the processing unit 52 confirms that the operator performs a re-entry, the processing becomes Yes at step S103 and proceeds to step S104. At step S104, the processing unit 52 holds the current input information, and the processing returns to step S101 to confirm the receipt of input. Note that whether the operator performs a re-entry is confirmed based on an input of the input unit 55, for example.

When it is confirmed that the operator has not performed re-entry, the processing becomes No at step S103 and proceeds to step S105. At step S105, the processing unit 52 determines whether there is information to be acquired via the Internet in information not included in the input information 70. Note that whether the operator has not performed re-entry may be confirmed based on receipt of an input indicating non-selection from the operator or expiration of a predetermined period during which no input is received.

In addition, examples of the acquisition of information via the Internet may include acquisition of information from a website published on the Internet, acquisition of information from a database on a server on the Internet, and the like. Further, the examples of acquisition of information via the Internet may also include a wide variety of methods of acquiring information available on the Internet by connecting to the Internet.

Examples of information to be acquired via the Internet may include a rolling resistance 11r, which is the resistance in the information 1S of the moving body 1, and the transition C1 of the speed of the movement pattern 1C. In addition, the computer 51 may acquire information other than the above-mentioned information via the Internet.

When the computer 51 determines that there is information to be acquired via the Internet, the processing becomes Yes at step S105 and proceeds to step S106. At step S106, the computer 51 acquires the target information via the Internet, and the processing proceeds to step S107. In addition, when the computer 51 determines that there is no information to be acquired via the Internet, the processing becomes No at step S105 and proceeds to step S107. At step S107, the processing unit 52 confirms whether the information stored in the storage unit 53 can be used as information not included in the input information 70.

Examples of the usable information in the information stored in the storage unit 53 may include information, such as expressions, for determining each item of information of the loss information 71. Alternatively, information used in previous calculations may be stored in the storage unit 53, and the processing unit 52 may acquire it from the storage unit 53. In addition, generally used information may be stored in the storage unit 53, and the processing unit 52 may acquire the information stored in the storage unit 53.

When the processing unit 52 determines that there is usable information in the information stored in the storage unit 53, the processing becomes Yes at step S107 and proceeds to step S108. Note that step S107 and step S108 may be executed before step S105. That is, the acquisition of information via the Internet and the use of the information stored in the storage unit 53 may be performed in any order.

At step S108, the processing unit 52 acquires information from the storage unit 53, and the processing proceeds to step S109. In addition, when the processing unit 52 determines that the storage unit 53 has no usable information, the processing becomes No at step S107 and proceeds to step S109. Further, at step S102, when the processing unit 52 determines that there is no information not included in the input information 70, the processing becomes No at step S102 and proceeds to step S109.

At step S109, the processing unit 52 executes the motor characteristic calculation module 62 to calculate the TN characteristics St, the current map Mp and the efficiency η of the motor 3 based on the specification 3S of the motor 3, the loss information 71, the environment information 72, and the other information 73 of the input information 70. Note that the calculation of the TN characteristics St, the current map Mp and the efficiency η includes a process of storing into the storage unit 53. Thereafter, the processing proceeds to step S110.

At step S110, the processing unit 52 executes the requirement condition calculation module 63 to calculate the transition 1N of the required rotational speed Nc required for the motor 3 with a change in the elapsed time t and the transition 1M of the required torque Tc with a change in the elapsed time t based on the information 1S of the moving body 1, the movement pattern 1C, and the other information 73 of the input information 70. Note that the calculation of the transition 1N of the required rotational speed Nc with a change in the elapsed time t and the transition 1M of the required torque Tc with a change in the elapsed time t includes a process of storing into the storage unit 53. The processing proceeds to step S111.

At step S111, the processing unit 52 executes the output module 64 to output the cruising distance 1D, the cruising time 1T, and the power consumption 1P based on the TN characteristics St, the current map Mp, the transition 1N of the required rotational speed Nc with a change in the elapsed time t, and the transition 1M of the required torque Tc with a change in the elapsed time t. Then, the processing proceeds to step S112. At step S112, the computer 51 sends the cruising distance 1D, the cruising time 1T, and the power consumption 1P to the output unit 56 of the input/output device 54, and displays them on the output unit 56.

As described above, the design method of the present embodiment uses, as the input information 70, at least the specification 3S of the motor 3, the information 1S of the moving body 1, the movement pattern 1C, and the information about the battery 41S. Further, the processing unit 52 can output the cruising distance 1D, the cruising time 1T, and the power consumption 1P by executing the program 60. That is, the cruising distance, the cruising time and the power consumption of the moving body can be acquired by using, as input information, the specification of the motor, the information about the moving body, the movement pattern of the moving body, and the information about the battery.

Note that as described above, the input information 70 may include the loss information 71, the environment information 72, and the other information 73. When the input information 70 includes the loss information 71, the environment information 72, and the other information 73, the cruising distance 1D, the cruising time 1T, and the power consumption 1P of the electric vehicle 11 including the loss and the environmental condition can be acquired.

In addition, the above-described processing is configured to supplement insufficient portions of the input information via the Internet and from the storage unit 53, but this is not limitative. It is possible to employ a configuration that can use a method of performing output without using insufficient portions when the input information has insufficient portions.

Design Method

The above-described simulation can be used for designing the electric vehicle 11, which is the moving body 1. A design method for the electric vehicle 11 is described below with reference to the accompanying drawings.

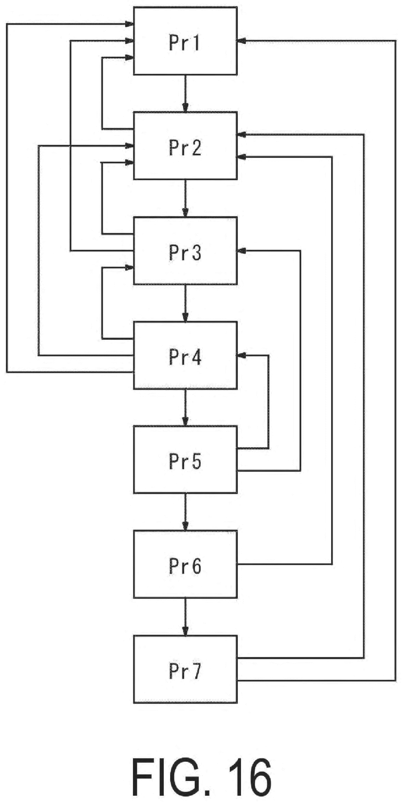

First, a design method for the motor 3 used for a known electric vehicle 11 is described. As illustrated in FIG. 16, the known design method is divided into seven steps. It is assumed that a designer performs the process in each step. Note that the designer may be a single worker or a team including a plurality of workers, for example. First, in a first step Pr1, the specification of the electric vehicle 11 is examined. The specification of the electric vehicle 11 is the vehicle class or the cruising distance of the electric vehicle 11, for example. In consideration of market trends and performance of known electric vehicles, the designer and a customer discuss and determine the specification of the electric vehicle 11. In addition, in the first step Pr1, the designer also assumes detailed specifications of the electric vehicle 11. Examples include the capacity of the battery 41 mounted on the electric vehicle 11, the radius R of the wheel 12, and the vehicle shape of the electric vehicle 11 that affects air resistance of the electric vehicle 11.

In a second step Pr2, the specification of the motor 3 mounted on the electric vehicle 11 is examined. More specifically, the specification of the motor 3 required for satisfying the specification of the electric vehicle 11 determined in the first step Pr1 is examined. Examples of the specification of the motor 3 examined in the second step Pr2 include the rotational speed N3 of the motor 3 and the torque T3 of the motor 3. Note that the designer of the second step Pr2 often differs from the designer of the first step Pr1. The designer determines the specification of the motor 3 based on the track record of known products, experience, and simple calculations.

Note that in some cases the designer of the second step Pr2 may request the designer of the first step Pr1 to modify the specification of the electric vehicle 11. In this case, the processing returns to the first step Pr1 to modify the specification of the electric vehicle 11. The modification of the specification of the electric vehicle 11 includes a request to further acquire information other than the currently defined specification of the electric vehicle 11, such as information about the transmission ratio R13 of the power transmission mechanism 13, for example. In addition, a request to acquire other information may also be included.

A third step Pr3 is a process of performing detailed design of the motor 3. Specifically, in the third step Pr3, each parameter of the motor 3 is designed so as to satisfy the specification of the motor 3 determined in the second step Pr2. For example, the parameter is the magnetic flux density of the coil 32b. The designer of the third step Pr3 is the designer of the motor, and therefore often differs from the designer of the electric vehicle 11 of the first step Pr1, and, in some cases, from the designer of the second step Pr21. When a parameter that satisfies the specification of the motor 3 cannot be determined, the designer of the third step Pr3 notifies the designer of the second step Pr2 or the like of such fact to modify the specification.

In the third step Pr3, a design blueprint of the motor 3 is created. The designer of the third step Pr3 can request the designer of the first step Pr1 or the second step Pr2 to modify the specification of the electric vehicle 11 or the specification of the motor 3. When a request for modification is made by the designer of the third step, the processing returns to the first step or the second step to modify the specification of the electric vehicle 11 or the specification of the motor 3.

In a fourth step Pr4, the motor 3 is prototyped. The designer of the fourth step Pr4 is mainly an implementation engineer of the motor 3, and prototypes the motor 3 so as to satisfy the detailed design of the motor 3 determined in the third step Pr3. For example, the number of turns and the winding method of the coil 32b are devised so as to satisfy the designed magnetic flux density. If the requirement cannot be satisfied, the magnetic material may be improved or developed anew in some cases.

The designer of a fifth step Pr5 is mainly a test engineer of the motor 3, and performs a standalone test for the motor 3 prototyped in the fourth step Pr4. The standalone test includes tests of basic electrical characteristics such as an open test and a short test, and tests of startup characteristics and no-load characteristics of the motor 3 using a single-axis bench, for example. In the standalone test, the torque T3 of the motor 3, the rotational speed N3 (the rotational speed of the rotor 31), vibration, noise, and the like are also tested.

In the standalone test in the fifth step Pr5, criteria are set. When it is determined that the criteria cannot be satisfied due to the design of the motor 3, the designer of the fifth step Pr5 requests the designer of the third step Pt3 to modify the design. In addition, when it is determined that the criteria cannot be satisfied due to the prototype or implementation of the motor 3, the designer of the fifth step Pr5 requests the designer of the fourth step Pr4 to perform prototyping or implementation again. Note that when requesting operation in the fourth step Pr4, the designer may request disassembly and reassembly, or may request assembly of a new prototype.

In a sixth step Pr6, a combined test is performed on the motor 3 satisfying the criteria in the fifth step Pr5. The combined test includes, for example, a two-axis bench test in which a dynamometer serving as a load is added and the test is performed in accordance with the movement pattern 1C, and a three-axis bench test in which the motor 3 having the gears 35, 36, 37, and 38 is tested. In addition, in the combined test, the torque T3 of the motor 3, the rotational speed N3 (the rotational speed of the rotor 31), vibration, noise, and the like are also tested.

In the combined test in the sixth step Pr6, criteria are set. When the criteria cannot be satisfied in the combined test in the sixth step Pr6, the designer of the sixth step Pr6 determines that the cause is the specification of the motor 3. Then, the designer of the sixth step Pr6 requests the designer of the second step Pt2 to modify the specification of the motor 3.

The designer of a seventh step Pr7 is mainly a test engineer of the electric vehicle 11. The test engineer attaches a prototype of the motor 3 satisfying the criteria of the combined test performed in the sixth step Pr6 to the actual electric vehicle 11 or its prototype, and performs a driving test in which the vehicle is driven on a road resembling the assumed actual road. In the driving test in the seventh step Pr7, the cruising distance 1D is measured, for example. Note that depending on the prototyping cost of the electric vehicle 11, the period, and the availability of a test road, evaluation in the seventh step Pr7 may not be performed in some cases.

In the driving test in the seventh step Pr7, criteria are set. In the seventh step Pr7, the criteria may not be satisfied in some cases. When it is determined that the current specification of the electric vehicle 11 cannot satisfy the criteria, the designer of the seventh step Pr7 requests the designer of the first step Pr1 to modify the specification of the electric vehicle 11. In addition, when it is determined that the specification of the motor 30 is unsatisfactory while the specification of the electric vehicle 11 is satisfactory, the designer requests the designer of the second step Pr2 to modify the specification of the motor 30. In addition, the motor 3 satisfying the criteria of the seventh step Pr7 is used as the motor 3 that can be used to drive the electric vehicle 11.

As described above, in the known design steps, the design of the electric vehicle 11 and the motor 3 involves many designers in different technical fields, such as the designer of the electric vehicle 11, the designer of the motor 3, the implementation engineer of the motor 3, the test engineer of the motor 3, and the test engineer of the electric vehicle 11. Further, the motor 3 is designed by repeating the above-described steps, namely the design steps in the first step Pr1 to the third step Pr3, the prototyping step in the fourth step Pr4, and the test step in the fifth step Pr5 to the seventh step Pr7. It is not possible to determine whether a modification made in each step is appropriate until the design steps are completed and an inspection is performed in the inspection step. That is, it is necessary to repeat a plurality of steps, resulting in a long lead time and high cost. In addition, since the steps are independent of each other, information may not be successfully communicated between the steps in some cases, which also causes the lead time and cost to increase.

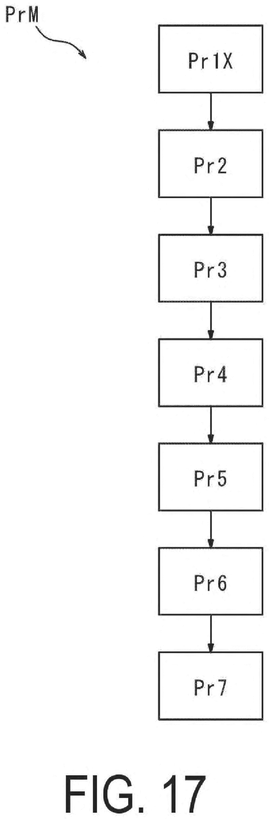

FIG. 17 illustrates a design method PrM for the electric vehicle 11 using the system 50 according to the embodiment. In the design method of FIG. 17, the first step Pr1 in the design method of FIG. 16 is replaced with a first design step Pr1X.

In the first step Pr1X of the design method PrM, the designer of the electric vehicle 11 determines the specification of the electric vehicle 11 using the system 50. For example, the specification of the electric vehicle 11 and the movement pattern 1C are assumed as initial values and input to the system 50. Whether the cruising distance 1D output by the system 50 satisfies the required value is confirmed. Further, the specification of the electric vehicle 11 is modified, and the optimum specification is examined.

The motor 3 is designed by performing the second step Pr2 and subsequent steps so as to satisfy the specification of the electric vehicle 11 determined in the first step Pr1X. In addition, although FIG. 17 eliminates returns to the respective processes, returns are not prohibited, and each process may be returned to as necessary.

The present inventors have found that the design period and cost of the electric vehicle 11 and the motor 3 can be greatly reduced based on knowledge from different fields, such as the design field of the electric vehicle 11, the design field of the motor 3, the implementation field of the motor 3, and the testing field of the motor 3. To achieve this, the inventors invented the system 50, the program 60, and the design method PrM by using knowledge from the different technical fields described above. In the system 50, the program 60, and the first step Pr1X of the design method PrM, the cruising distance 1D can be calculated with high accuracy since it is based on the information 1S of the moving body 1, the specification 3S of the motor 3, the movement pattern 1C, and the information 41S about the battery 41. Accordingly, it is possible to reduce returns to the respective steps in the design of the electric vehicle 11, thereby reducing the design period and cost.

First Modification

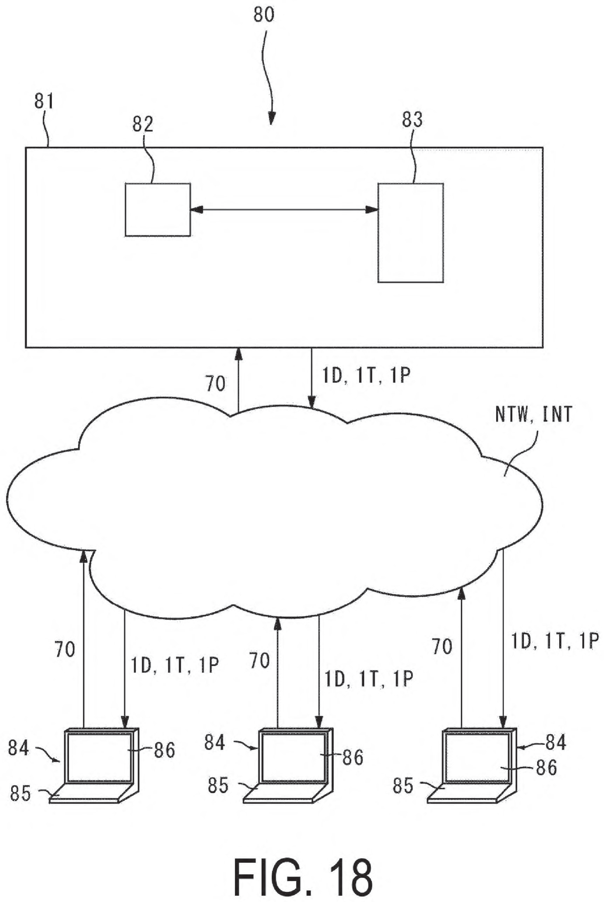

A system 80 of a first modification is described below with reference to the accompanying drawings. The system 80 illustrated in FIG. 18 is different from the system 50 in that it includes network NTW and employs a plurality of input/output devices 84. Other points are substantially the same as those of the system 50. Therefore, the parts of the system 80 that are substantially the same as those of the system 50 are denoted by the same reference numerals and the description thereof is omitted.

As illustrated in FIG. 18, the system 80 includes a server 81 and an input/output device 84. The server 81 includes a processing unit 82 including a processor such as a CPU and an MPU, and a storage unit 83 including a memory element such as a RAM, a ROM, a HDD, and an SSD. In the server 81, the storage unit 83 stores the simulation program 60. Further, in the server 81, the processing unit 82 can execute the program 60. That is, the server 81 serves as the computer 51 in the system 50.

The server 81 is installed on a network NTW, the plurality of input/output devices 84 are connected to the network NTW, and the plurality of input/output devices 84 are connected to the server 81 through the network NTW.

The input/output device 84 may each be a terminal capable of operating independently, such as a personal computer, a tablet PC, or a smartphone. In addition, the input/output device 84 may have a configuration specialized for input and output.

The input/output device 84 is a device that can transmit information input at an input unit 85 to the server 81 through the network NTW. Examples of the information input at the input unit 85 may include the input information 70 for executing simulations. In addition, the input/output device 84 can receive information from the server 81 through the network NTW, and output it using an output unit 86. The information received from the server 81 also includes at least one of the cruising distance 1D, the cruising time 1T, and the power consumption 1P, which are results of simulations executed by the processing unit 82 disposed at the server 81.

With the plurality of input/output devices 84 connected to the server 81 through the network NTW, the input information 70 can be input through the plurality of input/output devices 84. In this manner, the processing unit 82 can perform centralized management. Thus, in the system 80, maintenance such as updating the program 60 can be simplified as compared with a case where systems that operate independently of each other are used.

Note that the network NTW may be a LAN to which only terminals specified by a business operator can connect, or may be the Internet INT, for example. When the network NTW is the Internet, the server 81 may use a virtual private network (VPN) to which only authorized input/output devices 84 can connect. In addition, the server 81 may be a cloud server.

Second Modification

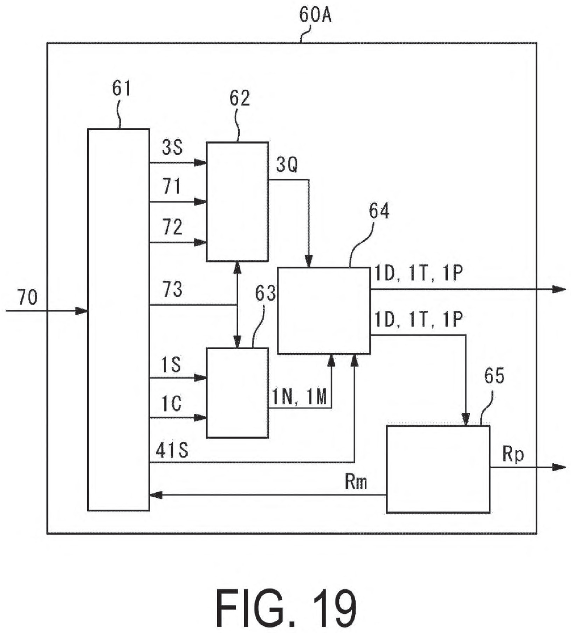

A second modification is described below with reference to the accompanying drawings. As illustrated in FIG. 19, a program 60A for executing a simulation of the second modification is different from the program 60 illustrated in FIG. 4 in that an optimum value output module 65 is employed. *The parts of the program 60A that are substantially the same as those of the program 60 are denoted by the same reference numerals and the description thereof is omitted.

As illustrated in FIG. 19, the program 60A includes the optimum value output module 65 that receives the cruising distance 1D, the cruising time 1T, and the power consumption 1P output from the output module 64. The optimum value output module 65 outputs an optimum value of at least one of the information included in the specification 3S of the motor 3 and the information included in the information 1S of the moving body 1 for improving the cruising distance 1D, the cruising time 1T, and the power consumption 1P. Specifically, the program 60A causes the computer 51 to output an optimum value of at least one of the specification 3S of the motor 3, the information 41S about the battery 41 and the information included in the information 1S of the moving body 1 based on at least one of the cruising distance 1D, the cruising time 1T, and the power consumption 1P.

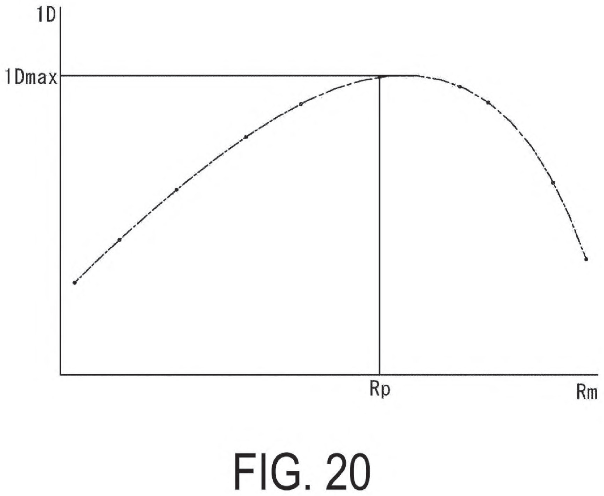

An output operation of an optimum value is described below. In the following description, as an output operation of an optimum value performed by the processing unit 52 executing the output module 64, a configuration is described in which the cruising distance 1D is output, and an optimum value of a radius value R of the wheel 12, as the shape of the rotating body, is output. FIG. 20 is a graph in which the abscissa indicates the radius value R of the wheel 12 and the ordinate indicates the cruising distance 1D.

When the processing unit 52 executes an optimum value output module 45, a changed value of the radius value R of the wheel 12 included in the information 1S of the moving body 1 of the input information 70 is output. The processing unit 52 executes the input module 61 to change the radius value R of the wheel 12 of the input information 70 to a value Rm. As illustrated in FIG. 20, the processing unit 52 outputs, as an optimum value Rp, the radius value R of the wheel 12 when the radius value R of the wheel 12 is changed and the value of the cruising distance 1D is maximized. Note that the radius value R of the wheel 12 is often a value predetermined by standards. As the optimum value Rp, the radius value R of the wheel that is closest to the value Rm set as the optimal value may be employed. Then, the computer 51 sends the optimum value Rp to the output unit 56 of the input/output device 54 together with a maximum value 1Dmax, and displays it on the output unit 56.

Note that the optimum value output module 45 outputs the optimum value Rp of the radius value R of the wheel 12 that increases the cruising distance 1D, but this is not limitative. For example, an optimum value that increases the cruising time 1T may be output. Alternatively, an optimum value that reduces the power consumption 1P may be output. In any case, the optimum value may be a radius value B3 of the wheel with which the output is maximized or locally maximized or an approximate value thereof, when the radius value R of the wheel 12 is changed and the output resulting from the processing unit 52 executing the output module 64 is confirmed. In addition to the radius value R of the wheel 12, an optimum value of changeable information in the input information 70, such as the number of poles 3p and the transmission ratio R13 of the motor 3, may be determined.

In addition, an optimum value of the information 41S about the battery 41 may be determined. When the calculated cruising distance 1D is sufficiently larger than the required cruising distance, the optimum value output module 45 can execute the optimization process while reducing the capacity 41c of the battery 41. When the capacity 41c of the battery 41 decreases, the weight 41w of the battery 41 becomes lighter, and the weight 1w of the moving body 1 also becomes lighter. In this manner, the specification 3S of the motor 3 can be changed to more suitable values.

In addition, when outputting an optimum value of the input information 70, the optimum value output module 45 may select a next value based on the prior operations of outputting the optimum values. In addition, the processing unit 52 may separately output an optimum value based on a relationship between an output and input information for outputting an optimum value, such as a scatter diagram and a relational expression.

The processing unit 52 executes the optimum value output module 65 to output optimum values of the specification 3S of the motor 3 and the information included in the information 1S of the moving body 1. Further, by the processing unit 52 using the output for designing, the electric vehicle 11 with high performance can be designed. Note that in the present modification, the processing unit 52 may execute the optimum value output module 65, and the computer 51 may send the cruising distance 1D, the cruising time 1T, and the power consumption 1P to the output unit 56 of the input/output device 54.

Third Modification

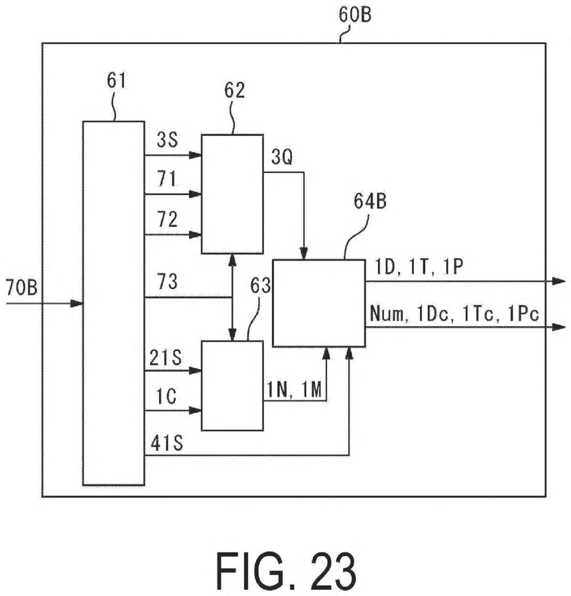

A third modification is described below with reference to the accompanying drawings. A simulation program 60B of the present modification illustrated in FIG. 23 differs in an output module 64B. In addition, as input information of the simulation program 60B, information 21S about an aircraft 21 is input instead of the information 1S of the moving body 1. Further, it is different from the simulation program 60 illustrated in FIG. 4 in that the output module 64B can output, in the aircraft 21, a number Num of stopped propellers 22, and the resulting cruising distance 1Dc, cruising time 1Tc, and power consumption 1Pc. The program 60B is substantially the same as the program 60 in other points. Therefore, the parts of the program 60B that are substantially the same as those of the program 60 are denoted by the same reference numerals and the description thereof is omitted.

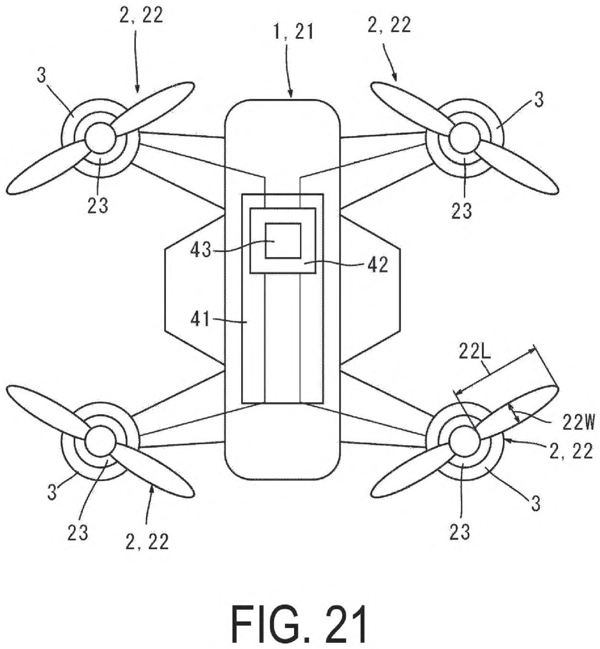

As illustrated in FIG. 21, in the present modification, the moving body is the aircraft 21. The aircraft 21 includes four motors 3. Further, the aircraft 21 includes four propellers 22 connected to each motor 3.

The aircraft 21 can levitate using lift generated by the rotation of the four propellers 22, perform attitude control, and control the traveling direction and speed by controlling the rotational speed and orientation of the propellers 22. An inverter 44 provided in the aircraft 21 can independently supply voltage to each of the four motors 3 by the controller 43. For example, the voltage supplied from the inverter 44 to the four motors 3 is PWM-controlled. In the inverter 44, the traveling speed and traveling direction are controlled by adjusting the PWM duty of the voltage supplied to each motor 3.

Next, input information 70B of a case where the aircraft 21 is used as the moving body 1 is described. In the input information 70B, the information substantially the same as the input information 70 is denoted by the same reference numerals and the description thereof is omitted.

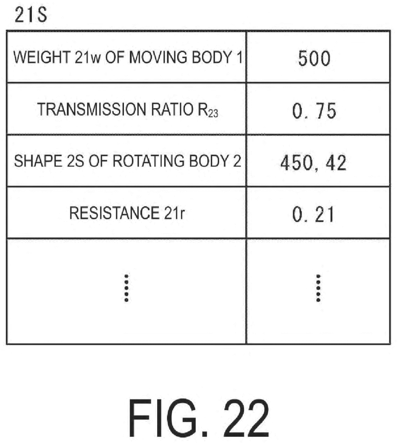

As illustrated in FIG. 22, information about the moving body 1 includes the information 21S about the aircraft 21. As illustrated in FIG. 22, the information 21S about the aircraft 21 includes a weight 21w, a transmission ratio R23, a shape 2S of the rotating body, and a resistance 21r. The weight is the weight of the aircraft 21. Assuming that the aircraft 21 is a manned type, the weight 21w includes the weights of a passenger and baggage. The transmission ratio R23 is the transmission ratio R23 of a power transmission mechanism 23 connecting the motor 3 and the rotary shaft of the propeller 22. When the motor 3 and the propeller 22 are directly connected, the transmission ratio R23 is 1.

The shape 2S of the rotating body includes information required for determining the force required for lifting and moving the aircraft 21 in the shape defining the characteristics of the propeller 22 as the rotating body 2. Examples of the shape of the rotating body may include a length 22L of the vane in the radial direction, and a width 22W of the vane in the rotational direction. Further, the examples may also include the number of the propellers 22, the number of vanes of each propeller 22, the propeller pitch, and the inclination angle. Further, in addition to these values, the shape of the rotating body may include other values as information for specifying the shape of the rotating body.

The resistance 21r includes resistance generated during movement of the aircraft 21. The resistance 21r includes the air resistance of the aircraft 21 during flight. Note that examples of air resistance may include the frontal projection area and the air resistance coefficient of the aircraft 21. In addition, the resistance 21r may include information other than these.

In addition, regarding the movement pattern 1C, although the details of the items are the same, the specific numerical values, graphs, relational expressions and the like differ depending on whether the moving body 1 is the electric vehicle 11 or the aircraft 21.

As illustrated in FIG. 23, the motor characteristic calculation module 62 and the requirement condition calculation module 63 of the program 60B calculate the characteristics 3Q of the motor 3, the transition 1N of the required rotational speed Nc with a change in the elapsed time t and the transition 1M of the required torque Tc with a change in the elapsed time t based on the arithmetic expression and the input information 70B. The TN characteristics St and the current map Mp are information about a single motor 3. In addition, the required rotational speed Nc and the required torque Tc are the torque required for moving the aircraft 21, and are values obtained by combining the torques of the plurality of motors 3.

The processing unit 52 executes the output module 64B to execute the same processing as with the execution of the output module 64. Specifically, the processing unit 52 outputs the cruising distance 1D, the cruising time 1T, and the power consumption 1P of the aircraft 21 from the TN characteristics St, the current map Mp, the transition 1N of the required rotational speed Nc with a change in the elapsed time t, and the transition 1M of the required torque Tc with a change in the elapsed time t.

On the other hand, the aircraft 21 may be configured such that it can move even when one of the four propellers 22 stops. As illustrated in FIG. 23, the processing unit 52 can execute the output module 64B to output, in the aircraft 21, the cruising distance 1Dc, the cruising time 1Tc, and the power consumption 1Pc for the case where one propeller 22 stops.

Note that the present modification describes a case where the moving body includes the four motors 3 and propellers 22, and one of them stops, but this is not limitative. For example, in the case where flight is still possible even when two or more of them stop, the cruising distance 1Dc, the cruising time 1Tc and the power consumption 1Pc may be output from the arithmetic expression and input information when two or more of them stop. In addition, the number of motors 3 included in the moving body is not limited to four, and the number Num of stopped motors 3 for which the flight can be maintained is not limited to one.

In this manner, in the aircraft 21 including the plurality of motors 3, the program 60B of the third modification can output the cruising distance 1D, the cruising time 1T, and the power consumption 1P of the aircraft 21 with all motors 3 in operation. In addition, it can also output, together with the number Num of stopped motors 3, the cruising distance 1Dc, the cruising time 1Tc and the power consumption 1Pc of the aircraft 21 with some of the motors 3 stopped.

The aircraft 21 can be designed by the same design method as that of the electric vehicle 11. Specifically, the processing unit 52 designs the aircraft 21 collectively by calculating the required rotational speed Nc and the required torque Tc required for the motor 3 using the specification 3S of the motor 3, the information 21S about the aircraft 21, the movement pattern 1C, the loss information 71 of the motor 3, and the like. This eliminates the need for testing the motor 3 alone or the power unit including the motor 3, thereby facilitating the design of a moving body including the motor 3.

In the embodiments described above, the electric vehicle 11 and the aircraft 21 have been described as examples of the moving body 1; however, the present disclosure is not limited thereto. In addition to these, it is possible to employ a wide variety of moving bodies, such as a vessel and an electric motorcycle, configured to be movable and including a motor serving as a power source and a battery that supplies electric power to the motor. The input information varies depending on the characteristics of the moving body, such as the configuration of the moving body and the place in which the moving body moves; however, the input information includes at least the specification of the motor, the information about the moving body, the movement pattern 1C, and the information about the battery.

Although embodiments of the present disclosure have been described above, the embodiments can be variously modified within the scope of the gist of the present disclosure.

Overview

The present disclosure includes the following configurations.
(1) A program configured to:

use, as input information to a computer, at least a specification of a motor, information about a moving body moved by the motor, a movement pattern of the moving body, and information about a battery configured to supply power to the motor; and
cause the computer to output at least one of a cruising distance, a cruising time, and a power consumption of the moving body based on the input information.

(2) The program according to (1), in which

the motor includes a rotor, and
the specification of the motor includes at least one of a weight of the rotor, a gear ratio of the motor, a rotational speed of the motor, a torque of the motor, and power information.

(3) The program according to (1) or (2), in which

the moving body includes a rotating body configured to be rotated by the motor to move the moving body,
the motor is configured to perform a regenerative operation of generating power by being rotated by the rotating body, and
the information about the moving body includes at least one of a weight of the moving body, a transmission ratio of a power transmission mechanism provided between the motor and the rotating body, an outer diameter of the rotating body, a resistance generated through movement of the moving body, and information about the regenerative operation.

(4) The program according to any one of (1) to (3), in which the movement pattern of the moving body includes at least one of a traveling speed, a traveling time, a transition of a speed in a predetermined period, and a transition of acceleration in a predetermined period.
(5) The program according to any one of (1) to (4), in which the information about the battery includes at least one of a type of the battery, a capacity of the battery, an internal resistance, and a degradation state.
(6) The program according to any one of (1) to (5), in which

the moving body includes an inverter provided between the battery and the motor, and
the input information includes loss information including at least one of a copper loss, an iron loss, a stray loss, a friction loss, a wind loss, and an inverter loss.

(7) The program according to any one of (1) to (6), in which the input information includes an environmental condition including at least one of a temperature of the motor and a temperature of the moving body.

(8) The program according to any one of (1) to (7), in which the computer is caused to output an optimum value of at least one of the specification of the motor, the information about the battery, and information included in the information about the moving body based on at least one of the cruising distance, the cruising time, and the power consumption.

(9) A system including:

an input unit configured to receive input information; and
a computer configured to execute output processing of outputting at least one of a cruising distance, a cruising time, and a power consumption of a moving body based on the input information, in which
the input information includes at least a specification of a motor, information about the moving body moved by the motor, a movement pattern of the moving body, and information about a battery configured to supply power to the motor.

(10) The system according to (9), in which

the motor includes a rotor, and
the specification of the motor includes at least one of a weight of the rotor, a gear ratio of the motor, a rotational speed of the motor, a torque of the motor, and power information.

(11) The system according to (9) or (10), in which

the moving body includes a rotating body configured to be rotated by the motor to move the moving body,
the motor is configured to perform a regenerative operation of generating power by being rotated by the rotating body, and
the information about the moving body includes at least one of a weight of the moving body, a transmission ratio of a power transmission mechanism provided between the motor and the rotating body, an outer diameter of the rotating body, a resistance generated through movement of the moving body, and information about the regenerative operation.

(12) The system according to any one of (9) to (11), in which the movement pattern of the moving body includes at least one of a traveling speed, a traveling time, a transition of a speed in a predetermined period, and a transition of acceleration in a predetermined period.

(13) The system according to any one of (9) to (12), in which the information about the battery includes at least one of a type of the battery, a capacity of the battery, an internal resistance, and a degradation state.

(14) The system according to any one of (9) to (13), in which

the moving body includes an inverter provided between the battery and the motor, and
the input information includes loss information including at least one of a copper loss, an iron loss, a stray loss, a friction loss, a wind loss, and an inverter loss.

(15) The system according to any one of (9) to (14), in which the input information includes an environmental condition including at least one of a temperature of the motor and a temperature of the moving body.

(16) The system according to any one of (9) to (15), in which the computer outputs an optimum value of at least one of the specification of the motor, the information about the battery, and information included in the information about the moving body based on at least one of the cruising distance, the cruising time, and the power consumption.

(17) A design method including outputting at least one of a cruising distance, a cruising time, and a power consumption of a moving body moved by power of a motor based on input information by using, as the input information, at least a specification of the motor, information about the moving body, a movement pattern of the moving body, and information about a battery configured to supply power to the motor.

(18) The design method according to (17), in which

the motor includes a rotor, and
the specification of the motor includes at least one of a weight of the rotor, a gear ratio of the motor, a rotational speed of the motor, a torque of the motor, and power information.

(19) The design method according to (17) or (18), in which

the moving body includes a rotating body configured to be rotated by the motor to move the moving body,
the motor is configured to perform a regenerative operation of generating power by being rotated by the rotating body, and
the information about the moving body includes at least one of a weight of the moving body, a transmission ratio of a power transmission mechanism provided between the motor and the rotating body, an outer diameter of the rotating body, a resistance generated through movement of the moving body, and information about the regenerative operation.

(20) The design method according to any one of (17) to (19), in which the movement pattern of the moving body includes at least one of a traveling speed, a traveling time, a transition of a speed in a predetermined period, and a transition of acceleration in a predetermined period.

(21) The design method according to any one of (17) to (20), in which the information about the battery includes at least one of a type of the battery, a capacity of the battery, an internal resistance, and a degradation state.

(22) The design method according to any one of (17) to (21), in which

the moving body includes an inverter provided between the battery and the motor, and
the input information includes loss information including at least one of a copper loss, an iron loss, a stray loss, a friction loss, a wind loss, and an inverter loss.

(23) The design method according to any one of (17) to (22), in which the input information includes an environmental condition including at least one of a temperature of the motor and a temperature of the moving body.

(24) The design method according to any one of (17) to (23), in which an optimum value of at least one of the specification of the motor, the information about the battery, and information included in the information about the moving body is output based on at least one of the cruising distance, the cruising time, and the power consumption.

Features of the above-described preferred embodiments and the modifications thereof may be combined appropriately as long as no conflict arises.

While preferred embodiments of the present disclosure have been described above, it is to be understood that variations and modifications will be apparent to those skilled in the art without departing from the scope and spirit of the present disclosure. The scope of the present disclosure, therefore, is to be determined solely by the following claims.

REFERENCE SIGNS LIST

1 moving body, 2 rotating body, 3 motor, 11 electric vehicle, 12 wheel, 13, 23 power transmission mechanism, 21 aircraft, 22 propeller, 31 rotor, 35-38 gear, 41 battery, 42 inverter, 50 system, 51 computer, 56 input unit, 60 program, 70 input information, 71 loss information, 72 environment information, 3S specification of the motor, 1C movement pattern, 1S information of the moving body, 41S information 41S about the battery

**Claims**

1. A program configured to:

   use, as input information to a computer, at least a specification of a motor, information about a moving body moved by the motor, a movement pattern of the moving body, and information about a battery configured to supply power to the motor; and
   cause the computer to output at least one of a cruising distance, a cruising time, and a power consumption of the moving body based on the input information.

2. The program according to claim 1, wherein

   the motor includes a rotor, and
   the specification of the motor includes at least one of a weight of the rotor, a gear ratio of the motor, a rotational speed of the motor, a torque of the motor, and power information.

3. The program according to claim 1, wherein

the moving body includes a rotating body configured to be rotated by the motor to move the moving body,

the motor is configured to perform a regenerative operation of generating power by being rotated by the rotating body, and

the information about the moving body includes at least one of a weight of the moving body, a transmission ratio of a power transmission mechanism provided between the motor and the rotating body, a shape of the rotating body, a resistance generated through movement of the moving body, and information about the regenerative operation.

4. The program according to claim 1, wherein the movement pattern of the moving body includes at least one of a traveling speed, a traveling time, a transition of a speed in a predetermined period, and a transition of acceleration in a predetermined period.

5. The program according to claim 1, wherein the information about the battery includes at least one of a type of the battery, a capacity of the battery, an internal resistance, and a degradation state.

6. The program according to claim 1, wherein

the moving body includes an inverter provided between the battery and the motor, and

the input information includes loss information including at least one of a copper loss, an iron loss, a stray loss, a friction loss, a wind loss, and an inverter loss.

7. The program according to claim 1, wherein the input information includes an environmental condition including at least one of a temperature of the motor and a temperature of the moving body.

8. The program according to claim 1 to 7, wherein the computer is caused to output an optimum value of at least one of the specification of the motor, the information about the battery, and information included in the information about the moving body based on at least one of the cruising distance, the cruising time, and the power consumption.

9. A system comprising:

an input unit configured to receive input information; and

a computer configured to execute output processing of outputting at least one of a cruising distance, a cruising time, and a power consumption of a moving body moved by a motor based on the input information, wherein the input information includes at least a specification of the motor, information about the moving body, a movement pattern of the moving body, and information about a battery configured to supply power to the motor.

10. The system according to claim 9, wherein

the motor includes a rotor, and

the specification of the motor includes at least one of a weight of the rotor, a gear ratio of the motor, a rotational speed of the motor, a torque of the motor, and power information.

11. The system according to claim 9, wherein

the moving body includes a rotating body configured to be rotated by the motor to move the moving body,

the motor is configured to perform a regenerative operation of generating power by being rotated by the rotating body, and

the information about the moving body includes at least one of a weight of the moving body, a transmission ratio of a power transmission mechanism provided between the motor and the rotating body, a shape of the rotating body, a resistance generated through movement of the moving body, and information about the regenerative operation.

12. The system according to claim 9, wherein the movement pattern of the moving body includes at least one of a traveling speed, a traveling time, a transition of a speed in a predetermined period, and a transition of acceleration in a predetermined period.

13. The system according to claim 9, wherein the information about the battery includes at least one of a type of the battery, a capacity of the battery, an internal resistance, and a degradation state.

14. The system according to claim 9, wherein

the moving body includes an inverter provided between the battery and the motor, and
the input information includes loss information including at least one of a copper loss, an iron loss, a stray loss, a friction loss, a wind loss, and an inverter loss.

15. The system according to claim 9, wherein the input information includes an environmental condition including at least one of a temperature of the motor and a temperature of the moving body.

16. The system according to claim 9 to 15, wherein the computer outputs an optimum value of at least one of the specification of the motor, the information about the battery, and information included in the information about the moving body based on at least one of the cruising distance, the cruising time, and the power consumption.

17. A design method comprising outputting at least one of a cruising distance, a cruising time, and a power consumption of a moving body moved by power of a motor based on input information by using, as the input information, at least a specification of the motor, information about the moving body, a movement pattern of the moving body, and information about a battery configured to supply power to the motor.

18. The design method according to claim 17, wherein

the motor includes a rotor, and
the specification of the motor includes at least one of a weight of the rotor, a gear ratio of the motor, a rotational speed of the motor, a torque of the motor, and power information.

19. The design method according to claim 17, wherein

the moving body includes a rotating body configured to be rotated by the motor to move the moving body,
the motor is configured to perform a regenerative operation of generating power by being rotated by the rotating body, and
the information about the moving body includes at least one of a weight of the moving body, a transmission ratio of a power transmission mechanism provided between the motor and the rotating body, a shape of the rotating body, a resistance generated through movement of the moving body, and information about the regenerative operation.

20. The design method according to claim 17, wherein the movement pattern of the moving body includes at least one of a traveling speed, a traveling time, a transition of a speed in a predetermined period, and a transition of acceleration in a predetermined period.

21. The design method according to claim 17, wherein the information about the battery includes at least one of a type of the battery, a capacity of the battery, an internal resistance, and a degradation state.

22. The design method according to claim 17, wherein

the moving body includes an inverter provided between the battery and the motor, and
the input information includes loss information including at least one of a copper loss, an iron loss, a stray loss, a friction loss, a wind loss, and an inverter loss.

23. The design method according to claim 17, wherein the input information includes an environmental condition including at least one of a temperature of the motor and a temperature of the moving body.

24. The design method according to claim 17 to 23, wherein an optimum value of at least one of the specification of the motor, the information about the battery, and the information about the moving body is output based on at least one of the cruising distance, the cruising time, and the power consumption.

FIG. 1

FIG. 2

FIG. 3

FIG. 4

3S

| NUMBER OF POLES | 8 |
|---|---|
| WEIGHT 31w OF ROTOR | 22 |
| GEAR RATIO $R_3$ | 0. 724 |
| ROTATIONAL SPEED INFORMATION 3N OF MOTOR 3 | 8000 |
| TORQUE INFORMATION 3T OF MOTOR 3 | 250 |
| INDUCTANCE | 7. 2. 7. 5 |
| FLUX LINKAGE | 1. 0 |
| ELECTRICAL CHARACTERISTICS 3E OF MOTOR 3 | 300 |
| ⋮ | ⋮ |

# FIG. 5

1S

| | |
|---|---|
| WEIGHT 1w OF MOVING BODY | 3, 000 |
| TRANSMISSION RATIO R13 | 1. 12 |
| SHAPE 2S OF ROTATING BODY 2 | 350 |
| RESISTANCE 1r OF MOVING BODY 1 | 0. 33 |
| REGENERATIVE OPERATION INFORMATION 1g | 10 |
| ⋮ | ⋮ |

# FIG. 6

1C

| TRAVELING SPEED 1V OF MOVING BODY 1 | 60 |
|---|---|
| TRAVELING TIME 1E OF MOVING BODY 1 | 8 |
| TRANSITION 1Vt OF SPEED V AT ELAPSED TIME t OF MOVING BODY 1 | |
| TRANSITION 1at OF ACCELERATION a AT ELAPSED TIME t OF MOVING BODY 1 | |
| ⋮ | ⋮ |

# FIG. 7

41S

| TYPE 41L OF BATTERY 41 | LITHIUM ION |
|---|---|
| CAPACITY 41c OF BATTERY 41 | 60 |
| INTERNAL RESISTANCE 41r OF BATTERY 41 | 300 |
| DEGRADATION STATE 41d OF BATTERY 41 | 85 |
| ⋮ | ⋮ |

# FIG. 8

71

| COPPER LOSS $P_{Cu}$ | 1. 7 |
|---|---|
| IRON LOSS $P_{fe}$ | 0. 21 |
| STRAY LOSS $P_{str}$ | 0. 03 |
| FRICTION LOSS $P_f$ | 0. 293 |
| WIND LOSS $P_w$ | 0. 001 |
| INVERTER LOSS $P_{inv}$ | 120<br>0. 500 |
| ⋮ | ⋮ |

# FIG. 9

72

| | |
|---|---|
| TEMPERATURE 3d OF MOTOR 3 | 84 |
| TEMPERATURE 1d OF MOVING BODY 1 | 26 |
| ⋮ | ⋮ |

# FIG. 10

FIG. 11

FIG. 12

FIG. 13

FIG. 14

FIG. 15

FIG. 16

PrM

Pr1X

Pr2

Pr3

Pr4

Pr5

Pr6

Pr7

# FIG. 17

# FIG. 18

FIG. 19

FIG. 20

FIG. 21

21S

| | |
|---|---|
| WEIGHT 21w OF MOVING BODY 1 | 500 |
| TRANSMISSION RATIO $R_{23}$ | 0. 75 |
| SHAPE 2S OF ROTATING BODY 2 | 450, 42 |
| RESISTANCE 21r | 0. 21 |
| ⋮ | ⋮ |

# FIG. 22

FIG. 23

## INTERNATIONAL SEARCH REPORT

| International application No. |
|---|
| **PCT/JP2024/034554** |

| A. | CLASSIFICATION OF SUBJECT MATTER |
|---|---|

*B60L 3/00*(2019.01)i; *B60L 7/14*(2006.01)i; *B60L 50/60*(2019.01)i
FI:  B60L3/00 N; B60L50/60; B60L7/14

According to International Patent Classification (IPC) or to both national classification and IPC

| B. | FIELDS SEARCHED |
|---|---|

Minimum documentation searched (classification system followed by classification symbols)

B60L3/00; B60L7/14; B60L50/60

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2019-108014 A (DAIMLER AG) 04 July 2019 (2019-07-04) claim 1, paragraphs [0005]-[0054], fig. 1 | 1-2, 4-6, 9-10, 12-14, 17-18, 20-22 |
| Y | | 3, 7-8, 11, 15-16, 19, 23-24 |
| Y | JP 2012-091774 A (EQUOS RESEARCH CO., LTD.) 17 May 2012 (2012-05-17) claim 1 | 3, 8, 11, 16, 19, 24 |
| Y | paragraphs [0062]-[0063], [0073] | 7, 15, 23 |
| A | JP 2023-109081 A (HONDA MOTOR CO., LTD.) 07 August 2023 (2023-08-07) entire text, all drawings | 1-24 |

☐ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 November 2024** | **03 December 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/034554**

| Patent document cited in search report | | | Publication date (day/month/year) | Patent family member(s) | Publication date (day/month/year) |
|---|---|---|---|---|---|
| JP | 2019-108014 | A | 04 July 2019 | (Family: none) | |
| JP | 2012-091774 | A | 17 May 2012 | (Family: none) | |
| JP | 2023-109081 | A | 07 August 2023 | US 2023/0234470 A1 entire text, all drawings CN 116494828 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2014064364 A